# FASCICULE DE BREVET EUROPEEN

(11) **EP 2 601 131 B1**
(45) Date de publication et mention de la délivrance du brevet: **07.12.2016**
(21) Numéro de dépôt: 11739066.6
(22) Date de dépôt: 03.08.2011
(51) Int. Cl.: B81B 7/00, B25J 7/00, B01F 13/08, B81C 99/00, B82Y 25/00, B82Y 40/00, H01F 41/30

(54) **PROCÉDÉ DE FABRICATION D'UNE PINCE MAGNÉTIQUE MICROMÉTRIQUE OU NANOMÉTRIQUE**
VERFAHREN ZUR HERSTELLUNG EINER MIKROSKALIGEN ODER NANOSKALIGEN PINZETTE
PROCESS FOR FABRICATING A MICROSCALE OR NANOSCALE MAGNETIC TWEEZER

(30) Priorité: 04.08.2010 FR 1056447
(43) Date de publication de la demande: 12.06.2013
(73) Titulaire: Commissariat à l'Énergie Atomique et aux Énergies Alternatives, 75015 Paris (FR)
(72) Inventeur: DIENY, Bernard, F-38250 Lans en Vercors (FR); SABON, Philippe, F-38430 Moirans (FR); JOISTEN, Hélène, F-38000 Grenoble (FR)
(74) Mandataire: Lebkiri, Alexandre
(86) Numéro de dépôt international: PCT/EP2011/063403
(87) Numéro de publication internationale: WO 2012/017024

(56) Documents cités:
- WO-A1-2009/111737
- US-A1- 2006 180 884
- US-A1- 2009 092 509
- HAN-TANG SU ET AL: "A Novel Underwater Actuator Driven by Magnetization Repulsion/Attraction", MICRO ELECTRO MECHANICAL SYSTEMS, 2009. MEMS 2009. IEEE 22ND INTERNATIONAL CONFERENCE ON, IEEE, PISCATAWAY, NJ, USA, 25 janvier 2009 (2009-01-25), pages 1051-1054, XP031444478, ISBN: 978-1-4244-2977-6 cité dans la demande
- GIOUROUDI ET AL: "Development of a microgripping system for handling of microcomponents", PRECISION ENGINEERING, ELSEVIER, vol. 32, no. 2, 25 février 2008 (2008-02-25), pages 148-152, XP022497336, ISSN: 0141-6359, DOI: DOI:10.1016/J.PRECISIONENG.2007.07.002
- DONG-HYUN KIM ET AL.: "BIOFUNCTIONALIZED MAGNETIC-VORTEX MICRODISCS FOR TARGETED CANCER-CELL DESTRUCTION", NATURE MATERIALS, vol. 9, février 2010 (2010-02), pages 165-171, XP002638226, cité dans la demande

## Description

La présente invention concerne une pince magnétique de taille micrométrique ou nanométrique et un procédé de fabrication d'une telle pince. La présente invention concerne également l'utilisation d'une telle pince magnétique.

Des micro ou nanoparticules magnétiques sont de plus en plus utilisées pour des applications en biotechnologie ou biomédical. La publication intitulée « "Applications of magnetic nanoparticles in biomedicine", Q.A. Pankhurst, J. Connolly, S.K. Jones, J. Dobson, UK, Australia, J. of Phys. D : Appl. Phys. 36, R167-R181, 2003, décrit par exemple l'utilisation de particules magnétiques dans le domaine biomédical. L'intérêt de ce type de particules réside dans la possibilité d'exercer à distance une force sur ces particules par l'application d'un champ magnétique. Cette action mécanique peut permettre de guider les particules lors de leur déplacement, de les concentrer à certains endroits, de les déformer, de les exciter magnétiquement pour qu'elles dissipent de l'énergie et s'échauffent ou alors pour les faire vibrer. Le document intitulé « Heating ability of magnetite nanobeads with various sizes for magnetic hyperthermia at 120 kHz, a non invasive frequency", K. Okawa, M. Sekine, M. Maeda, M. Tada, M. Abe, N. Matsushita, K. Nishio, H. Handa, Tokyo Inst. Tech, Japan, J. of Appl.Phys. 99, 08H102, 2006 » décrit par exemple l'utilisation de particules magnétiques pour produire de la chaleur.

En utilisant les particules magnétiques seules ou en greffant à leur surface différents types de molécules permettant la reconnaissance de certaines espèces moléculaires ou cellulaires et/ou une action sur ces espèces, de nombreuses applications sont possibles. Parmi celles-ci, on peut citer la délivrance ciblée de molécules de traitement (drug delivery), la séparation de molécules ou de cellules en suspension, les traitements de cancer par hyperthermie, l'ingénierie de tissus cellulaires, les agents de contraste en IRM...

Jusqu'à présent, les particules magnétiques citées ci-dessus pour les biotechnologies ont été développées essentiellement pour leur capacité à être déplacées dans un fluide par l'action d'un gradient de champ magnétique. Par exemple, pour les applications biomédicales ou biologiques de délivrance ciblée de médicaments (« drug delivery »), ou de séparation moléculaire en solution, les particules magnétiques sont utilisées pour être déplacées et guidées dans le fluide à l'aide de sources de gradients de champ magnétique extérieur. Pour certaines applications biomédicales comme pour l'ingénierie de tissus cellulaires, l'objectif est de tracter et guider des objets biologiques greffés sur des particules magnétiques.

Mais dans tous les cas décrits précédemment, les particules magnétiques sont formées par un volume simple, mécaniquement peu déformable, qui peut seulement être transporté comme un bloc rigide.

D'autre part, l'état de la technique a vu se développer des micro-pinces magnétiques de type MEMS (ou « Microelectromechanical systems » en anglais) qui peuvent être activées sous l'action d'un champ magnétique. La publication intitulée « A novel under water actuator driven by magnetization repulsion/attraction », Han-Tang Su, Tsung-Lin, Tang, W. Fang, Nat. T.H. Univ., HsinChu, Taiwan, 1051-1054, IEEE 2009, décrit par exemple des micro-pinces magnétiques comportant deux languettes parallèles, fixées à un support. Sous l'action d'un champ magnétique, ces languettes se déforment de façon à se rapprocher l'une de l'autre ou à s'éloigner. Ces deux languettes peuvent ainsi saisir des objets sur leur tranche.

Ces micro-pinces magnétiques sont particulièrement avantageuses car elles peuvent permettre de saisir des objets à distance, de délivrer des objets à distance, et ce même en milieu liquide.

Toutefois, ces pinces magnétiques présentent des dimensions relativement importantes (en effet leurs languettes mesurent environ 600 µm). En outre, l'état de la technique ne connaît pas de procédé permettant de miniaturiser ces pinces.

Par ailleurs, ces pinces ne peuvent fonctionner que fixées sur un substrat, ce qui limite leur utilisation, et l'état de la technique ne comprend pas de procédé de fabrication des micropinces permettant la libération des micropinces du substrat.

En outre, la fabrication de ces pinces est relativement compliquée et difficilement automatisable.

Par ailleurs, les pinces magnétiques de l'art antérieur sont telles que, tout en restant fixées à un support, les positions relatives des deux parties de ces pinces magnétiques sont dans une configuration figée : soit avec deux branches parallèles au substrat et dans le même plan, qui pincent les objets avec leur tranche, d'où une faible surface pour attraper un objet ; soit avec deux branches qui pincent les objets par leurs surface planes, mais qui sont rattachées perpendiculairement au substrat, ce qui n'est pas compatible avec une fabrication collective d'un ensemble de particules planes obtenues collectivement par les techniques de la microélectronique.

Le document US 2009/092509 A1 décrit une méthode de fabrication d'une pince magnétique dans laquelle deux fils magnétiques microscopiques sont mis en contact au moyen d'un manipulateur magnétique, ces fils étant reliés entre eux par un adhésif flexible. Le procédé selon l'invention vise à remédier aux inconvénients de l'état de la technique en permettant d'obtenir des particules magnétiques de taille aussi petites que les particules magnétiques utilisées habituellement dans le domaine biomédical mais qui sont déformables de façon contrôlable.

Le procédé selon l'invention vise également à obtenir des pinces magnétiques de taille micrométrique ou nanométrique inférieure à la taille des pinces magnétique de l'état de la technique.

Le procédé selon l'invention vise de plus à obtenir des micro-pinces ou nano-pinces magnétiques qui puissent être détachées du substrat et fonctionner en suspension dans une solution.

Le procédé selon l'invention vise aussi à obtenir des micro-pinces ou nano-pinces qui puissent se déplacer en solution sous l'action d'un champ magnétique.

Le procédé selon l'invention vise également à obtenir des micro-pinces ou nano-pinces qui présentent une grande surface de préhension.

Pour ce faire, est proposé un procédé de fabrication d' une pince magnétique comportant deux mâchoires formées chacune par au moins une couche mince magnétique, les deux mâchoires s'étendant suivant une direction longitudinale, les deux mâchoires étant couplées magnétostatiquement, les deux mâchoires étant reliées entre elles par une charnière déformable, la charnière s'étendant suivant une direction transversale, les deux mâchoires pouvant être mises en mouvement l'une par rapport à l'autre sous l'action d'un champ magnétique.

Par « couche mince », on entend on entend toute couche de matière déposée par des technologies issues de la micro- ou nanoélectronique telles que l'électrodéposition, l'évaporation, etc.... Les gammes des épaisseurs possibles dépendant des limites des technologies existantes, évoluant avec la technique, actuellement situées entre le dixième de nanomètre à plusieurs dizaines de micromètres, et usuellement comprises entre le nanomètre et quelques micromètres.

La direction longitudinale est également appelée direction Y dans la suite. La direction transversale est perpendiculaire à la direction longitudinale. Dans la suite, la direction transversale sera également appelée direction Z.

Ainsi, la pince magnétique obtenue par le procédé selon l'invention est constituée d'au moins deux couches minces magnétiques mobiles l'une par rapport à l'autre et reliées par un de leur côté par une charnière déformable, de préférence élastiquement. C'est la capacité de cette charnière transversale à se déformer qui permet l'ouverture ou la fermeture de l'angle formé par les mâchoires de la pince magnétique.

La charnière utilisée dans le procédé selon l'invention relie de préférence les mâchoires uniquement entre elles et non pas à un support. La pince magnétique selon l'invention peut donc être utilisée indépendamment de tout support.

Dans ce document, on appelle « surface extérieure d'une mâchoire », la surface de la mâchoire qui ne fait pas face à l'autre mâchoire. Au contraire, on appelle « surface intérieure d'une mâchoire », la surface de la mâchoire qui fait face à l'autre mâchoire. On appelle « tranche latérale » d'une des mâchoires ou de la pince, le côté de la mâchoire ou de la pince, qui est normal à la direction longitudinale et sur lequel se trouve la charnière. On appelle « tranche » d'une des mâchoires ou de la pince les autres côté de la mâchoire ou de la pince sur lesquels ne se trouvent pas la charnière.

La pince magnétique obtenue par le procédé selon l'invention peut également présenter une ou plusieurs des caractéristiques ci-dessous, considérées individuellement ou selon toutes les combinaisons techniquement possibles.

Avantageusement, la pince magnétique obtenue par le procédé selon l'invention est une micro-pince ou une nano-pince, c'est-à-dire qu'elle présente des dimensions micrométriques ou nanométriques.

Avantageusement, chacune des mâchoires présente une longueur inférieure à 0.5 mm, de préférence inférieure à 200 µm.

Selon un mode de réalisation préférentiel, la pince magnétique obtenue par le procédé selon l'invention est une nanoparticule, c'est-à-dire que chacune des trois dimensions est comprise entre 0.2 et 300 nanomètres.

Chaque mâchoire peut être formée par une seule couche mince magnétique ou par plusieurs couches minces magnétiques, voire même par un empilement de couches comportant lui-même des couches minces magnétiques.

Selon différents modes de réalisation, les deux mâchoires peuvent être constituées soit du même matériau magnétique, soit de deux matériaux magnétiques différents, chacun de ces matériaux magnétiques pouvant être dur ou doux du point de vue magnétique. Chacune des mâchoires peut être formée d'une monocouche ou d'une multicouche.

Selon un mode de réalisation préférentiel, au moins une des mâchoires est formée dans un matériau magnétique doux. En effet, si les 2 mâchoires sont en matériaux magnétiques durs, l'actionnement magnétostatique de la pince sera obtenu en appliquant un champ magnétique supérieur aux champs coercitifs des matériaux, donc ce champ magnétique devra être plus important que dans le cas où les deux mâchoires sont formées d'un matériau magnétique doux.

Lorsqu'au moins une des mâchoires comporte un matériau magnétique doux, ce matériau magnétique peut, selon un mode de réalisation, être en Permalloy, qui est un alliage NiFe de composition proche de 80% de Ni et 20% de Fe, ou autres alliages doux à base de Ni, Fe et Co (par exemple Co₉₀Fe₁₀).

Lorsqu'au moins une des mâchoires comporte un matériau magnétique dur, ce matériau magnétique dur peut être, selon différents modes de réalisation :
- en alliage terre rare/métaux de transition (par exemple SmCo), ou
- une multicouche magnétique, par exemple constituée de l'association d'une couche antiferromagnétique couplée à une couche douce ferromagnétique se trouvant piégée par anisotropie d'échange, cette bicouche antiferromagnétique/ferromagnétique pouvant être répétée plusieurs fois.

Avantageusement, les couches minces qui forment les mâchoires présentent une anisotropie magnétique uniaxiale très bien définie, c'est-à-dire qu'elles présentent un axe d'orientation privilégiée de l'aimantation. Selon un mode de réalisation, l'axe d'anisotropie peut par exemple être dans le plan des couches magnétiques, selon la direction longitudinale ou sa perpendiculaire, ou être perpendiculaire au plan des couches selon la direction transversale. Selon un autre mode de réalisation, un ou plusieurs axes d'anisotropie peuvent être définis selon des directions différentes dans chaque mâchoire. Ainsi, l'axe d'anisotropie d'une première mâchoire peut par exemple être défini selon une première direction, l'axe d'anisotropie de la deuxième mâchoire étant défini selon une deuxième direction, la première et la deuxième directions étant symétriques par rapport au plan bissecteur de l'angle entre les mâchoires.

L'origine de l'anisotropie des couches minces qui forment les mâchoires peut être diverse : elle peut être d'origine magnétostatique, magnétocristalline, magnétoélastique, etc.

De telles anisotropies magnétiques uniaxiales peuvent être réalisées en faisant des dépôts de matériaux magnétiques sous champ magnétique. Par exemple, des couches de Permalloy Ni₈₀Fe₂₀ présentent une telle anisotropie uniaxiale lorsqu'elles sont déposées sous champ magnétique. On peut aussi induire une anisotropie uniaxiale en réalisant le dépôt du matériau magnétique sur un substrat en incidence oblique. La couche magnétique présente alors une anisotropie uniaxiale dans le plan de la couche, perpendiculaire au plan d'incidence des espèces déposées. On peut également réaliser des empilements multicouches présentant une anisotropie uniaxiale perpendiculaire au plan des couches. C'est le cas par exemple des multicouches (Pt 2nm/Co 0.6nm)ₙ. Dans ce type de multicouches, il existe une anisotropie hors du plan, d'origine cristallographique ou interfaciale pouvant dépasser l'anisotropie de forme d'origine magnétostatique. Dans les couches minces, l'anisotropie de forme tend à maintenir l'aimantation des couches magnétiques dans le plan de ces dernières. Mais dans les multicouches (Pt/Co), l'anisotropie perpendiculaire d'origine interfaciale arrive à vaincre l'anisotropie de forme de sorte que les aimantations des couches de cobalt pointent perpendiculairement aux interfaces. Ces systèmes présentent ainsi une anisotropie magnétique uniaxiale très bien définie qui est perpendiculaire au plan des couches.

Selon différents modes de réalisation, les mâchoires peuvent :
- présenter un couplage magnétique antiparallèle lorsqu'aucun champ magnétique n'est appliqué. Dans ce cas, lorsqu'aucun champ magnétique n'est appliqué, la pince magnétique est fermée. Par contre, lorsqu'un champ magnétique est appliqué avec une intensité supérieure ou égale à un des champs coercitifs d'un des matériaux magnétiques de la pince, ce champ magnétique ramène une projection des aimantations des mâchoires parallèles au champ appliqué, et pointant dans la même direction, ce qui induit une attraction d'origine magnétostatique entre les deux mâchoires, et donc l'ouverture de la pince ; le couplage magnétique antiparallèle est de préférence dirigé selon la direction longitudinale, bien que toute autre orientation puisse être envisagée, ou
- présenter un couplage magnétique parallèle lorsqu'aucun champ magnétique n'est appliqué. Dans ce cas, lorsqu'aucun champ magnétique n'est appliqué, les deux mâchoires se repoussent, de sorte que la pince magnétique est ouverte. Au contraire, lorsqu'un champ magnétique est appliqué, les deux mâchoires s'attirent, de sorte que la pince magnétique se referme.

Selon un mode de réalisation, au moins une des mâchoires est recouverte, au moins partiellement, d'un matériau fonctionnalisable, en un endroit où l'on prévoit de greffer des espèces chimiques ou biologiques.

On entend par « matériau fonctionnalisable » un matériau sur lequel on peut greffer des espèces chimiques ou biologiques. Lorsque l'on veut greffer des molécules biologiques sur les mâchoires, ce matériau fonctionnalisable peut par exemple être de l'or ou de la silice.

Selon un autre mode de réalisation, chaque mâchoire est recouverte, au moins partiellement d'un matériau biocompatible. Lorsque la pince magnétique est destinée à être introduite dans un milieu biologique, par exemple un corps humain ou animal, la pince magnétique est de préférence entièrement recouverte d'un matériau biocompatible. Lorsque la pince magnétique n'est pas destinée à être introduite dans un corps humain ou animal, seules les parties de la pince magnétique qui seront en contact avec de la matière biologique peuvent être recouvertes d'un matériau biocompatible. Le matériau biocompatible peut, par exemple, être de l'or ou de la silice. Le matériau biocompatible forme de préférence une ou plusieurs couche(s) mince(s) à la surface de la pince magnétique.

Selon un mode de réalisation, la surface intérieure et/ou la surface extérieure des mâchoires sont/est fonctionnalisé(s). Des espèces chimiques ou biologiques peuvent ainsi être greffées sur la surface extérieure et/ou intérieure des mâchoires. Cette fonctionnalisation permet par exemple de favoriser la prise de certaines espèces chimiques ou biologiques cibles par la pince magnétique. En outre, cette fonctionnalisation peut permettre à la pince de ne pas relarguer les espèces chimiques ou biologiques cibles qu'elle attrape, et ce, même lorsque la pince magnétique s'ouvre alors qu'elle contient certaines espèces entre ses mâchoires. En effet, ces espèces chimiques ou biologiques cibles se lient aux espèces chimiques ou biologiques fixées sur les mâchoires de la pince magnétique, de sorte que les espèces chimiques ou biologiques cibles restent fixées aux espèces chimiques ou biologiques fixées sur les mâchoires de la pince malgré l'ouverture de la pince.

Avantageusement, la charnière est déformable élastiquement.

Avantageusement, la charnière forme une liaison pivot plan d'axe X perpendiculaire à l'axe Y longitudinal et à l'axe Z transversal. Les mâchoires sont de préférence aptes à pivoter autour de cet axe X sous l'effet d'un champ magnétique grâce à la déformation de la charnière. Ainsi, lorsqu'un champ magnétique est appliqué, les mâchoires pivotent l'une par rapport à l'autre grâce à la déformation de la charnière: en effet, les extrémités des mâchoires qui sont solidaires de la charnière restent fixes ou quasiment fixes, selon l'élasticité de la charnière, tandis que les extrémités de chacune des mâchoires qui sont libres s'éloignent l'une de l'autre.

Selon différents modes de réalisation, la charnière peut être constituée :
- d'une couche mince déformable élastiquement. Cette couche mince est de préférence réalisée dans un métal ductile de type or, argent, cuivre ou platine ou tout autre matériau élastique ayant une résistance à la fatigue suffisante et apte à être déposé sur les mâchoires ; cette couche élastique déformable pouvant être métallique ou pas, éventuellement magnétique ;
- d'éléments moléculaires, chimiques ou biologiques qui lient ensemble les deux mâchoires de la pince magnétique. Dans ce cas où la charnière est formée par des éléments biologiques (par exemple par des brins d'ADN, d'ARN, des anticorps, antigènes...), une couche biocompatible (Au, SiO₂ ...) doit être déposée sur la tranche latérale des mâchoires pour permettre le greffage de ces éléments biologiques sur la tranche latérale des mâchoires.

Selon différents modes de réalisation, la couche mince déformable élastiquement qui constitue la charnière peut recouvrir :
o à la fois la surface extérieure des deux mâchoires et la tranche latérale des deux mâchoires. Dans ce cas, la charnière enveloppe les deux mâchoires de la pince magnétique. Une telle charnière est particulièrement avantageuse lorsque les mâchoires effectueront des grands mouvements l'une par rapport à l'autre ; ou
o la surface extérieure d'une des mâchoires et la tranche latérale des deux mâchoires. Dans ce cas, la charnière enveloppe seulement une des mâchoires et la tranche latérale des deux mâchoires, ou
o la tranche latérale et une partie de la surface extérieure d'au moins une mâchoire
o seulement la tranche latérale des deux mâchoires.

Selon différents modes préférentiels de réalisation de l'invention :
- la charnière est formée d'une couche mince déformable en matériaux organiques, en polymère ou en résine résistante aux solvants utilisés pour les couches sacrificielles ; ou
- la charnière est formée de silice.

Le procédé selon l'invention permet de fabriquer des pinces magnétiques de toutes formes et de toutes tailles, y compris des pinces magnétiques de tailles nanométriques.

Un autre objet de l'invention est de proposer un procédé permettant de fabriquer simultanément un grand nombre de micro ou nano-pinces magnétiques.

Un autre objet de l'invention est de proposer un procédé permettant de fabriquer facilement un grand nombre de pinces micro ou nanométriques.

Pour ce faire, le procédé de fabrication selon l'invention de la pince magnétique, à la surface d'un substrat, comporte les étapes suivantes :
(i)- formation d'un empilement à la surface du substrat, l'empilement comportant au moins deux couches minces magnétiques entre lesquelles se trouve une couche sacrificielle, les deux couches minces étant couplées magnétostatiquement, l'empilement présentant une section longitudinale égale à la section longitudinale voulue pour la pince magnétique à réaliser, l'empilement présentant une tranche latérale ;
(ii)- dépôt d'une charnière sur au moins la tranche latérale de l'empilement;
(iii)- attaque et suppression de la couche sacrificielle.

Ainsi, le procédé de fabrication selon l'invention est particulièrement remarquable en ce qu'une couche sacrificielle est déposée entre les couches minces qui forment les mâchoires, de façon à maintenir les deux mâchoires ensemble mais à distance tant que la charnière n'a pas été déposée. La charnière maintient ensuite les deux mâchoires ensemble, et la couche sacrificielle peut alors être dissoute.

Chaque mâchoire est formée par une des couches minces magnétiques de l'empilement. Ces couches minces magnétiques présentent à travers la couche sacrificielle un couplage magnétique. Ainsi, les couches minces et la couche sacrificielle sont choisies de façon à ce que les couches minces présentent un couplage magnétique à travers la couche sacrificielle, c'est-à-dire que l'on choisit les matériaux qui constituent les couches minces magnétiques et la couche sacrificielle ainsi que l'épaisseur de ces couches, et les conditions de dépôt de ces couches de façon à obtenir ce couplage.

Par exemple, les couches minces magnétiques de l'empilement peuvent être déposées sous champ magnétique.

Avantageusement, les deux mâchoires de la pince, formées chacune par une des couches minces, s'étendent parallèlement à la surface du substrat. La charnière s'étend, elle, perpendiculairement à la surface du substrat.

Chaque mâchoire peut également être formée par plusieurs couches minces magnétiques et dans ce cas, l'empilement comporte plusieurs couches minces de chaque côté de la couche sacrificielle.

L'empilement peut également comporter en outre au moins une couche de matériau biocompatible.

L'empilement peut également comporter en outre au moins une couche de matériau fonctionnalisable.

Avantageusement, l'empilement réalisé lors de l'étape (i) forme une nanoparticule constituée de deux couches minces magnétiques entre lesquelles se trouve une couche sacrificielle.

L'empilement réalisé lors de l'étape (i) présente de préférence des dimensions inférieures à 300 nm.

La couche sacrificielle permet de maintenir les deux couches magnétiques qui forment les mâchoires ensemble mais à distance l'une de l'autre tant que la charnière n'a pas été déposée.

La charnière est ensuite déposée sur la tranche latérale de l'empilement.

Le procédé selon l'invention peut également comprendre, suite à l'étape (iii), une étape d'ouverture des mâchoires de la pince et de greffage d'espèces chimiques ou biologiques à l'intérieur des mâchoires de la pince magnétique.

Le procédé selon l'invention peut également comporter, suite à l'étape (iii), une étape de séparation de la pince magnétique du substrat par attaque et suppression d'une couche support qui sépare la pince magnétique du substrat.

L'étape (i) de réalisation de l'empilement peut être réalisée selon différents modes de réalisation.

Selon un premier mode de réalisation, l'étape (i) comporte les étapes suivantes :
- formation d'au moins un relief à la surface du substrat, le relief présentant une surface supérieure de section longitudinale égale à la section longitudinale voulue pour la pince magnétique à réaliser;
- dépôt d'au moins une première couche mince magnétique sur la surface supérieure de ce relief ;
- dépôt d'une couche sacrificielle sur la première couche mince ;
- dépôt d'au moins une deuxième couche mince magnétique à la surface de la couche sacrificielle.

Selon ce premier mode de réalisation, la surface du substrat est préstructurée de façon à former un moule dans lequel on vient déposer les différentes couches qui constituent l'empilement. La section longitudinale de l'empilement est alors définie par la section longitudinale du relief.

Selon différents modes de réalisation :
- le relief peut être formé par un ou plusieurs plots faisant saillie de la surface du substrat, ces plots étant séparés par des cavités. Dans ce cas, les différentes couches qui constituent l'empilement sont déposées au sommet de ce(s) plot(s). Le sommet de chaque plot présente une surface supérieure de section longitudinale qui définit la surface longitudinale de l'empilement et donc la surface longitudinale de la pince magnétique à réaliser ;
- le relief peut être formé par une ou plusieurs cavité(s) creusée(s) dans la surface du substrat, les cavités étant séparées par des plots. Dans ce cas, les différentes couches qui constituent l'empilement sont déposées au fond de cette ou ces cavité(s). Le fond de chaque cavité présente une surface de section longitudinale égale à la surface longitudinale de l'empilement et donc à la section longitudinale de la pince magnétique à réaliser. Dans le cas où chaque empilement est formé dans une cavité, une couche support est de préférence déposée à la surface du substrat préalablement à la réalisation de l'empilement de façon à pouvoir ensuite séparer les pinces magnétiques du substrat par élimination de cette couche support. Cette couche support est de préférence apte à être facilement dissoute à l'aide d'un solvant.

Ce procédé permet de fabriquer des pinces magnétiques de toute forme et de toute taille, puisque c'est le relief à la surface du substrat qui définit la forme et la dimension de la pince.

Selon un deuxième mode de réalisation, l'étape (i) de réalisation de l'empilement comporte les étapes suivantes :
- dépôt d'une couche support sur le substrat,
- formation d'un premier ensemble de plots et de cavités à la surface de la couche support, chaque cavité présentant un fond de section longitudinale égale à la section longitudinale voulue pour la mâchoire inférieure de la pince magnétique à réaliser;
- dépôt d'au moins une première couche mince magnétique;
- élimination du premier ensemble de plots et de cavités par gravure ;
- dépôt d'une couche sacrificielle de façon à ce que la surface supérieure de la couche sacrificielle soit plane et que la première couche mince soit entièrement recouverte par la couche sacrificielle ;
- formation d'au moins un deuxième ensemble de plots et de cavités à la surface de la couche sacrificielle, chaque cavité présentant un fond de section longitudinale égale à la section longitudinale voulue pour la mâchoire supérieure de la pince magnétique à réaliser,
- dépôt d'au moins une deuxième couche mince magnétique;
- élimination du deuxième ensemble de plots et de cavités et de la partie de la couche sacrificielle qui se trouve à l'extérieur de l'empilement par gravure sélective de façon à ne conserver sur la couche support que l'empilement de section longitudinale égale à la section longitudinale de la mâchoire supérieure de la pince à réaliser.

Avantageusement, l'étape de dépôt d'une couche sacrificielle de façon à ce que la surface supérieure de la couche sacrificielle soit plane peut également comporter une étape de planarisation de la surface supérieure de la couche sacrificielle déposée.

Avantageusement, le deuxième ensemble de plots et de cavités est identique au premier ensemble de plots et de cavités, et il est déposé au même endroit de la couche support que le premier ensemble de plots et de cavités.

Selon un mode de réalisation, l'étape de formation d'au moins un relief à la surface du substrat, l'étape de formation du premier ensemble de plots et de cavités et l'étape de formation du deuxième ensemble de plots et de cavités comporte chacune les étapes suivantes :
- dépôt d'une couche de résine à la surface du substrat,
- insolation de la résine par lithographie pour réaliser au moins un relief à la surface du substrat,
- élimination des parties insolées.

L'étape d'élimination des parties insolées peut être une étape de dissolution des parties insolées grâce à un solvant.

La lithographie utilisée peut être optique ou électronique.

Selon un autre mode de réalisation, l'étape de formation d'au moins un relief à la surface du substrat, l'étape de formation du premier ensemble de plots et de cavités et l'étape de formation du deuxième ensemble de plots et de cavités comporte chacune les étapes suivantes :
- dépôt d'une couche de résine à la surface du substrat,
- pressage d'un moule contenant l'empreinte du relief à réaliser sur la couche de résine ;
- réticulation de la résine, par exemple thermiquement ou par insolation UV.

L'étape de pressage est de préférence réalisée à chaud, à une température à laquelle la résine est relativement fluide, c'est-à-dire à une température supérieure ou proche de la température de transition vitreuse Tg du polymère constituant la résine. Cette résine peut par exemple être du PMMA ou polyméthylméthacrylate, chauffée à environ 180°C pour le pressage.

Avantageusement, la couche de résine déposée à la surface du substrat présente une épaisseur supérieure à l'épaisseur des pinces magnétiques que l'on cherche à réaliser. De cette façon, l'empilement qui est réalisé au sommet du relief est physiquement détaché de l'empilement réalisé au fond du relief (et inversement).

Selon un troisième mode de réalisation, l'étape (i) comporte les étapes suivantes:
- dépôt d'au moins une première couche mince magnétique à la surface du substrat ;
- dépôt d'une couche sacrificielle sur la première couche mince ;
- dépôt d'au moins une deuxième couche mince magnétique à la surface de la couche sacrificielle ;
- lithographie de la multicouche formée par la première couche mince magnétique, la deuxième couche mince magnétique et la couche sacrificielle de façon à former un empilement présentant une section longitudinale égale à la section longitudinale voulue pour la pince magnétique à réaliser.

Selon ce troisième mode de réalisation, une multicouche est d'abord réalisée sur toute la surface du substrat, puis cette multicouche est « taillée », de façon à ne conserver qu'une partie de la multicouche qui présente la section longitudinale voulue. La lithographie utilisée peut être optique ou électronique.

Dans ce cas, lorsque l'on souhaite réaliser des pinces magnétiques en solution, la surface supérieure du substrat est recouverte d'une couche support, qui est sacrificielle, et le procédé comporte en outre une étape de séparation de la pince magnétique du substrat par attaque et suppression de la couche support.

Les étapes de dépôt des couches magnétiques, de la couche sacrificielle, de la charnière lorsque celle-ci est formée d'une couche mince, sont par exemple réalisée par pulvérisation cathodique, mais elles peuvent également être réalisée par épitaxie par jet moléculaire, électrodéposition ou ALD (« Atomic Layer Deposition »).

Avantageusement, les étapes de dépôt de la première et de la deuxième couches minces de l'empilement sont réalisées sous un champ magnétique de façon à ce que la première et la deuxième couches minces présentent une anisotropie magnétique uniaxiale alignée sur ce champ.

L'étape (i) de formation de l'empilement peut également comprendre une ou plusieurs étapes de dépôt d'une couche de matériau biocompatible. Par exemple, lorsque l'on veut que la surface extérieure de la première mâchoire soit recouverte d'un matériau biocompatible, l'étape de dépôt de la première couche mince en matériau magnétique est précédée d'une étape de dépôt d'une couche en matériau biocompatible, par exemple en or ou en silice. Si l'on souhaite que la surface intérieure de la première mâchoire soit recouverte d'un matériau biocompatible, l'étape de dépôt de la première couche mince en matériau magnétique est suivie d'une étape de dépôt d'une couche de matériau biocompatible. Si l'on souhaite que la surface intérieure de la deuxième mâchoire soit recouverte d'un matériau biocompatible, l'étape de dépôt de la deuxième couche mince en matériau magnétique est précédée d'une étape de dépôt d'une couche de matériau biocompatible. Si l'on souhaite que la surface extérieure de la deuxième mâchoire soit recouverte d'un matériau biocompatible, l'étape de dépôt de la deuxième couche mince en matériau magnétique est suivie d'une étape de dépôt d'une couche de matériau biocompatible.

Lorsque la charnière est formée par une couche mince, elle peut être déposée suivant plusieurs modes de réalisation.

Selon un premier mode de réalisation, l'étape de dépôt de la charnière est réalisée en incidence oblique pour couvrir à la fois la tranche latérale des mâchoires et au moins une partie de la surface supérieure de la deuxième mâchoire. Dans ce cas, l'étape de dépôt du matériau qui constitue la charnière est par exemple réalisée par pulvérisation cathodique, PVD, CVD, ADL, électrodéposition, épitaxie par jet moléculaire...

Selon un autre mode de réalisation, le flanc de la charnière, qui est défini comme étant la partie de la charnière qui est perpendiculaire au substrat, peut être formé d'un pilier défini par lithographie optique ou électronique, le matériau constitutif du pilier étant déposé en incidence perpendiculaire au plan du substrat.

Dans ce cas, la charnière peut également comprendre une partie qui enveloppe la surface extérieure de la deuxième mâchoire (c'est-à-dire la mâchoire la plus éloignée du substrat). Dans ce cas, la partie supérieure de la charnière qui recouvre la surface de la deuxième mâchoire peut être réalisée par dépôt en incidence normale. Les termes « incidence normale » et « incidence perpendiculaire au substrat » sont équivalents.

La charnière peut également comprendre une partie qui enveloppe la surface extérieure de la première mâchoire (c'est-à-dire la mâchoire qui est la plus proche du substrat) et dans ce cas, le procédé selon l'invention comporte, préalablement à l'étape (i), une étape de dépôt d'une couche constituant la partie de la charnière qui enveloppe la première mâchoire.

Lorsque la charnière est formée de molécules qui relient les deux mâchoires, l'étape de réalisation de la charnière est de préférence réalisée par greffage des molécules qui constituent la charnière sur la tranche latérale des mâchoires.

Lorsque la charnière relie la première et la deuxième mâchoires, les mâchoires sont libérées l'une de l'autre en attaquant et supprimant, par exemple par dissolution à l'aide d'un solvant adapté, la couche sacrificielle, ou en détruisant la couche sacrificielle par plasma isotrope ou gravure anisotrope.

La pince fabriquée à l'aide du procédé selon l'invention est particulièrement avantageuse car, en jouant sur le champ magnétique appliqué, on peut saisir un objet à l'aide de la pince, le pincer, le maintenir bloqué, ou relarguer une molécule ou un objet biologique à un endroit précis.

La pince fabriquée à l'aide du procédé selon l'invention permet donc de manipuler un objet à distance en jouant sur le champ magnétique appliqué.

En outre, la pince magnétique fabriquée à l'aide du procédé selon l'invention peut être en suspension en solution et dans ce cas, elle peut être déplacée de manière contrôlée dans la solution grâce à l'application d'un champ magnétique d'intensité et de fréquence choisies. Le contrôle magnétique du déplacement de la pince en solution, in vitro ou in vivo, peut être obtenu par un gradient de champ magnétique appliqué et/ou par un champ magnétique appliqué variable dans le temps.

La micro- ou nanopince magnétique fabriquée à l'aide du procédé selon l'invention peut être ainsi utilisée pour les biotechnologies et le biomédical, mais également en microrobotique, nanomécanique, nano-optique...

La pince magnétique fabriquée à l'aide du procédé selon l'invention peut être utilisée pour saisir un objet à distance. Dans ce cas, un champ magnétique est appliqué de façon à ouvrir la pince magnétique et à la refermer sur ledit objet.

La pince magnétique fabriquée à l'aide du procédé selon l'invention peut être utilisée pour transporter un objet dans un liquide. Dans ce cas, une fois que la pince magnétique a saisi entre ses mâchoires l'objet, un gradient de champ magnétique peut être appliqué de façon à ce que la pince magnétique se déplace dans le liquide. La pince peut également être déplacée par des moyens non magnétiques. Elle peut par exemple être entraînée par un fluide en mouvement.

La pince fabriquée à l'aide du procédé selon l'invention peut être utilisée pour mesurer la force de liaison moléculaire d'une espèce chimique ou biologique présentant deux extrémités. Dans ce cas, chaque extrémité de l'espèce est fixée à une des mâchoires de la pince magnétique selon l'invention, et on mesure la résistance de l'espèce chimique ou biologique par le champ magnétique nécessaire pour provoquer l'ouverture de la pince magnétique malgré la présence de l'espèce chimique ou biologique fixée aux mâchoires de la pince. La force de répulsion ou d'attraction magnétostatique qui ouvre ou ferme la pince dépend des propriétés des matériaux magnétiques constituant les mâchoires, de leur aimantation à saturation, de leur comportement magnétique en fonction du champ appliqué, de l'intensité et de la fréquence du champ magnétique appliqué, et des volumes de matériaux magnétiques.

La magnétique fabriquée à l'aide du procédé selon l'invention peut également être utilisée pour mesurer la force de liaison moléculaire entre deux espèces chimiques ou biologiques, chaque espèce étant fixée à une des mâchoires de la pince magnétique. On détermine alors la force nécessaire pour ouvrir les mâchoires de la pince magnétique et donc la force nécessaire pour séparer les deux espèces l'une de l'autre. Pour cela, on détermine le champ magnétique nécessaire pour ouvrir les mâchoires de la pince magnétique malgré la présence des deux espèces entre les mâchoires de la pince magnétique, puis on en déduit la force nécessaire pour séparer les deux espèces l'une de l'autre.

Plusieurs pinces magnétiques fabriquées à l'aide du procédé selon l'invention peuvent être utilisées pour modifier la réflectivité d'une surface. Dans ce cas, les pinces magnétiques sont fixées à la surface de façon à ce que la mâchoire inférieure de chaque pince magnétique soit parallèle à la surface et un champ magnétique est appliqué de façon à actionner la mâchoire supérieure de la pince magnétique, ce qui permet de faire varier la réflectivité de la surface qui supporte les pinces. Dans ce cas, la surface extérieure de la deuxième mâchoire de la pince peut être recouverte d'un matériau très réfléchissant. Pour obtenir des pinces magnétiques selon l'invention fixées à la surface d'un substrat, il suffit de ne pas séparer les pinces magnétiques de leur support et ainsi la mâchoire inférieure reste fixée au substrat et la mâchoire supérieure actionnable par un champ magnétique appliqué.

La pince magnétique fabriquée à l'aide du procédé selon l'invention peut être utilisée pour chauffer un objet maintenu entre les mâchoires de la pince magnétique.

Dans ce cas, la pince magnétique maintient l'objet entre ces mâchoires et elle est soumise à un champ magnétique à une fréquence suffisamment élevée pour provoquer l'échauffement de la pince, c'est-à-dire de préférence une fréquence comprise entre quelques dizaines et quelques centaines de kilohertz. L'orientation du champ magnétique permettant l'échauffement de la pince dépend des matériaux utilisés pour les mâchoires de la pince magnétique.

Le champ magnétique alternatif appliqué à la pince magnétique dans ce cas présente de préférence une amplitude d'environ un centième de tesla. Le champ magnétique alternatif appliqué dans ce cas présente une orientation apte à ouvrir et fermer la pince magnétique. Par exemple, lorsque les mâchoires de la pince magnétique présente un couplage antiparallèle suivant la direction Y, le champ magnétique est dirigé suivant la direction Y. Lorsque ce champ magnétique alternatif est appliqué dans la région de l'espace où se trouve la pince magnétique, la pince magnétique reste fermée, filtrant les hautes fréquences du point de vue mécanique, tout en s'échauffant, et elle formera alors une sorte de « four » entourant l'objet capturé.

La pince fabriquée à l'aide du procédé selon l'invention peut être utilisée pour faire vibrer un objet maintenu entre les mâchoires de la pince magnétique, la pince magnétique étant soumise à un champ magnétique à une fréquence apte à provoquer la vibration de la pince.

Dans un procédé de déplacement de la pince magnétique fabriquée à l'aide du procédé selon l'invention, la pince magnétique étant en suspension dans un liquide, elle est soumise à un champ magnétique de fréquence suffisamment faible, c'est-à-dire de préférence comprise entre quelques hertz à quelques centaines de hertz, pour provoquer des petits battements des mâchoires de la pince, ce qui entraîne une translation de la pince magnétique dans la solution. En effet, le fait d'appliquer à la pince un champ magnétique alternatif à une fréquence relativement faible permet de créer des petits battements des mâchoires de la pince magnétique, ce qui lui permet de « nager » et donc de se déplacer dans la solution.

Si un gradient de champ magnétique est superposé à ce champ magnétique alternatif, cet effet « papillon » facilitera le déplacement de la pince magnétique selon la direction et le sens imposés par le gradient.

Par ailleurs, cet effet de « nage » peut également permettre de déplacer la pince magnétique sans gradient de champ magnétique. En effet, lorsque la pince magnétique est en solution, si la fréquence du champ magnétique est comprise entre 1 Hertz et quelques centaines de Hertz, de façon à actionner périodiquement les ouvertures et fermetures complètes des mâchoires de la pince magnétique, selon la viscosité de la solution et la forme du champ magnétique appliqué, un effet de «nage » de la pince pourra être provoqué, ce qui permettra à la particule de se déplacer sans gradient de champ appliqué, dans des zones éloignées où un gradient de champ serait difficile à obtenir. Pour que cette ouverture et fermeture alternative conduise à un mouvement de translation de la pince magnétique, il est nécessaire que le champ magnétique varie alternativement de façon dissymétrique : ainsi pour que la pince avance du côté de la charnière, il est nécessaire que la fermeture de la pince soit plus rapide que son ouverture à la manière d'une coquille St Jacques. Au contraire, pour que la pince magnétique aille dans la direction opposée à celle de la charnière il faut que l'ouverture soit plus rapide que la fermeture. Si des pinces sont orientées dans des directions différentes, cet effet de « nage » permettra de les séparer les unes des autres.

D'autres caractéristiques et avantages de l'invention ressortiront à la lecture de la description qui suit, en référence aux figures annexées, qui illustrent :
- les figures 1 a et 1 b, une vue en coupe transversale d'une pince magnétique selon un mode de réalisation de l'invention, respectivement en position fermée et ouverte,
- la figure 2a et 2b, une vue en coupe transversale d'une pince magnétique selon un autre mode de réalisation de l'invention, respectivement en position fermée et ouverte,
- la figure 3a et 3b, une vue en coupe transversale d'une pince magnétique selon un autre mode de réalisation de l'invention, respectivement en position fermée et ouverte,
- la figure 4a, une vue schématique en coupe transversale d'un empilement permettant de fabriquer une pince magnétique selon l'invention ;
- les figures 4b à 4d, des représentations schématiques des étapes d'un procédé permettant de fabriquer l'empilement de la figure 4a ;
- les figures 4e à 4h, des représentations schématiques des étapes d'un autre procédé permettant de fabriquer l'empilement de la figure 4a ;
- les figures 4i et 4j, des représentations schématiques des étapes d'un autre procédé permettant de fabriquer l'empilement de la figure 4a ;
- les figures 5a à 5h, des représentations schématiques d'étapes de réalisation de la charnière de pinces magnétiques selon l'invention ;
- la figure 6, une vue en coupe de pinces magnétiques selon l'invention qui sont fonctionnalisée,
- la figure 7, une représentation schématique en perspective de pinces magnétiques selon l'invention qui sont séparées de leur support,
- la figure 8, une représentation schématique en coupe d'une pince magnétique selon un mode de réalisation de l'invention qui est fonctionnalisée;
- la figure 9, une représentation schématique en coupe d'une pince magnétique selon un mode de réalisation de l'invention qui est utilisée pour saisir des objets ;
- la figure 10, une représentation schématique en coupe d'une pince magnétique selon un mode de réalisation de l'invention qui est utilisée pour chauffer un objet ;
- la figure 11, une représentation schématique en coupe d'une pince magnétique selon un mode de réalisation de l'invention qui effectue des petits battements ;
- la figure 12, une représentation schématique en coupe d'une pince magnétique selon un mode de réalisation de l'invention qui se déplace dans un fluide.

Pour plus de clarté, les éléments identiques ou similaires sont repérés par des signes de référence identiques sur l'ensemble des figures.

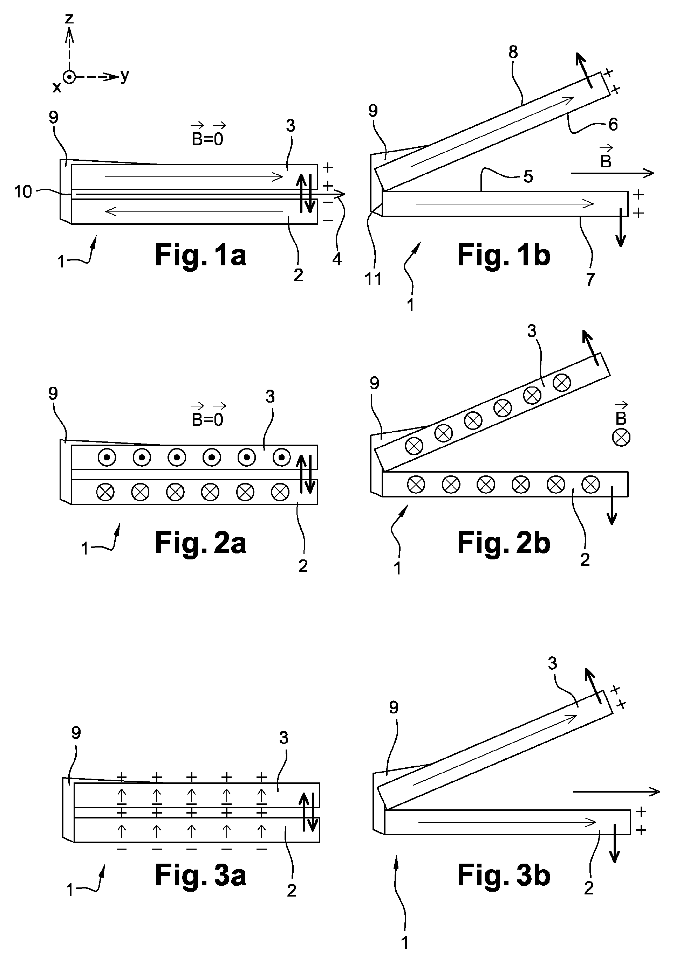

La figure 1 représente une vue en coupe d'une pince magnétique 1 obtenue selon un mode de réalisation de l'invention.

La pince magnétique 1 comporte une première mâchoire 2 et une deuxième mâchoire 3. Les deux mâchoires 2, 3 s'étendent suivant un axe longitudinal 4. Les deux mâchoires 2, 3 présentent chacune une surface intérieure 5, 6 et une surface extérieure 7, 8. On désigne par « surface intérieure », la surface d'une mâchoire qui fait face à l'autre mâchoire et par « surface extérieure » la surface opposée. Les surfaces intérieures et extérieures de chaque mâchoire s'étendent parallèlement à l'axe longitudinal 4. L'axe longitudinal 4 est parallèle à l'axe Y.

La pince magnétique 1 comporte également une charnière 9 qui relie ensemble les deux mâchoires par un de leur côté 10. La charnière s'étend suivant l'axe Z transversal. Le côté de la pince magnétique par lequel la charnière relie les mâchoires est appelé « tranche latérale» 11. La charnière est de préférence formée d'un film mince métallique. Le métal utilisé pour former la charnière peut être de l'or, du platine, de l'argent, du cuivre ou tout autre métal ductile.

Dans ce mode de réalisation, chaque mâchoire 2, 3 est formée par une couche mince en matériau magnétique. Cette couche mince est de préférence en alliage nickel-fer-cobalt de forme générale Ni_{1-x-y}FeₓCo_{y}, x et y étant des réels entre 0 et 1 caractérisant les concentrations relatives de Fe et de Co dans l'alliage. Les épaisseurs des deux mâchoires sont choisies de façon préférentielle de telles sortes que leur moment magnétique soit comparable. Ceci signifie ici que le produit de l'aimantation de la mâchoire par l'épaisseur de la mâchoire doit être sensiblement le même pour les deux mâchoires.

Les deux mâchoires 2, 3 présentent une anisotropie planaire uniaxiale selon l'axe Y. Plus précisément, dans ce mode de réalisation, l'interaction magnétostatique entre les aimantations des deux mâchoires 2 et 3 fait que spontanément, les aimantations des deux mâchoires s'orientent de façon antiparallèle pour qu'il y ait fermeture de flux magnétique entre les deux mâchoires.

Ainsi, en l'absence d'un champ magnétique, comme représenté sur la figure 1a, les mâchoires 2, 3 présentent un moment magnétique quasiment nul car les aimantations des couches successives qui constituent les mâchoires sont antiparallèles l'une par rapport à l'autre et leurs moments magnétiques respectifs sont comparables. Par contre, lorsqu'un champ magnétique B parallèle à l'axe Y est appliqué, comme représenté sur la figure 1b, ce champ magnétique B ramène les aimantations des couches minces qui constituent les mâchoires toutes parallèles, ce qui induit une forte répulsion magnétostatique entre les deux mâchoires, cette répulsion magnétostatique étant de même nature que la répulsion de deux barreaux aimantés dont on approche les pôles de même signe. Cette répulsion entraîne l'ouverture de la pince magnétique par déformation de la charnière, pour permettre aux mâchoires de s'éloigner l'une de l'autre.

Ainsi, on peut contrôler l'ouverture et la fermeture de la pince magnétique 1 en contrôlant le champ magnétique qui lui est appliqué.

Les figures 2a et 2b représentent une pince magnétique 1 obtenue selon un autre mode de réalisation de l'invention. Cette pince magnétique comporte deux mâchoires 2 et 3 reliées entre elles par une charnière 9. Chaque mâchoire est formée d'au moins une couche mince magnétique. Les mâchoires présentent une anisotropie uniaxiale planaire selon l'axe X. Les mâchoires présentent un couplage magnétique antiparallèle suivant l'axe X d'origine magnétostatique. Lorsqu'aucun champ magnétique n'est appliqué (figure 2a), les mâchoires 2, 3 s'attirent par interaction magnétostatique à la manière de deux barreaux aimantés dont on approche les pôles de signes contraires. La pince magnétique est donc fermée. Par contre, en cas de champ magnétique B suivant l'axe X appliqué, les aimantations des mâchoires deviennent parallèles et donc les mâchoires se repoussent, ce qui conduit à l'ouverture de la pince magnétique (figure 2b).

Les figures 3a et 3b représentent un autre mode de réalisation dans lequel les deux mâchoires 2 et 3 présentent, en l'absence d'un champ magnétique, une anisotropie uniaxiale hors du plan des couches suivant l'axe Z, qui est perpendiculaire aux couches magnétiques. En l'absence d'un champ magnétique appliqué, les moments magnétiques sont parallèles et placés bout à bout et par conséquent, les deux mâchoires s'attirent et donc la pince magnétique 1 reste fermée. Par contre, lorsqu'un champ magnétique B parallèle au plan XY est appliqué, l'aimantation de la première et de la deuxième mâchoires deviennent parallèles entre elles et au plan X,Y, de sorte que les deux mâchoires se repoussent et pivotent autour de l'axe X de façon à ce que la pince magnétique s'ouvre.

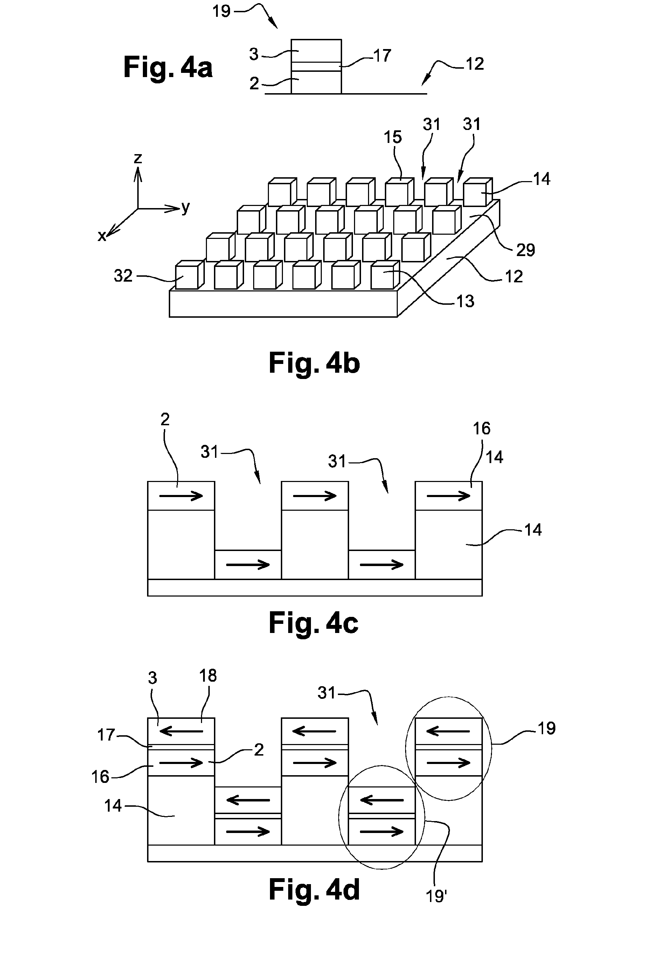

Un procédé de réalisation de pinces magnétiques selon l'invention va maintenant être décrit en référence aux figures 4a à 7.

Afin de faciliter la compréhension du procédé, on se place dans le cas où les pinces magnétiques que l'on cherche à réaliser présentent deux mâchoires présentant un couplage magnétique antiparallèle entre elles suivant l'axe Y en l'absence de champ magnétique appliqué. Les pinces magnétiques que l'on cherche à réaliser sont donc identiques à la pince magnétique représentées sur les figures 1 a et 1 b. L'homme du métier saurait adapter le procédé décrit ci-dessous à la fabrication d'autres pinces magnétiques selon l'invention.

Selon une première étape, on réalise tout d'abord à la surface d'un substrat 12 un empilement 19 comportant deux couches minces magnétiques, chaque couche mince formant une des mâchoires 2, 3 de la pince à réaliser. Entre ces deux couches minces magnétiques, l'empilement 19 comporte une couche sacrificielle 17. Cet empilement 19 doit présenter la même forme que la pince magnétique que l'on cherche à réaliser.

Cet empilement 19 doit comporter au moins deux couches minces magnétiques séparées par une couche sacrificielle. La couche sacrificielle peut être métallique, isolante ou semiconductrice ou à base de polymère. La couche sacrificielle doit pouvoir être éliminée sélectivement par rapport aux couches minces qui forment les mâchoires de la pince magnétique. Concernant les couches magnétiques incluses dans les mâchoires, l'empilement 19 peut être un empilement de couche magnétique d'alliages à base de Ni, Fe et de Co, d'épaisseur typique de quelques dizaines de nanomètres couplées antiferromagnétiquement par interactions magnétostatiques de part et d'autre de la couche sacrificielle. Cet empilement peut comprendre d'autres couches notamment servant à la biocompatibilité des matériaux et à la fonctionnalisation des diverses surfaces de la pince. Un tel empilement peut être réalisé selon différents modes de réalisation.

Les figures 4b à 4d représentent un premier mode de réalisation d'un tel empilement 19.

Dans ce premier mode de réalisation, on part d'un substrat 12 de surface lisse, par exemple en silicium.

On dépose ensuite une couche de résine polymère d'épaisseur homogène à la surface de ce substrat 12.

La couche de résine polymère d'épaisseur homogène peut par exemple être obtenue par un procédé d'enduction centrifuge (« spin coating » en anglais). Le principe consiste à étaler à l'aide de forces centrifuges une petite quantité de résine polymérique sur le substrat, par exemple à l'aide d'une tournette qui aspire la plaquette afin qu'elle ne soit pas éjectée lors de sa rotation.

La couche de résine polymère d'épaisseur homogène peut également être obtenue par évaporation de résine ou « spray coating ».

L'épaisseur de cette couche de polymère peut faire quelques dizaines de nanomètres à plusieurs microns.

L'épaisseur de la couche de résine polymère doit être supérieure à l'épaisseur des pinces magnétiques que l'on cherche à réaliser, afin que le dépôt réalisé au sommet des plots soit physiquement séparé de celui réalisé au fond des cavités séparant les plots.

Une fois, cette couche de polymère étalée sur la surface du substrat, on réalise dans cette couche de polymère des reliefs 13 qui présentent une section longitudinale égale à la section longitudinale des pinces magnétiques que l'on cherche à réaliser.

Dans cet exemple, les reliefs 13 que l'on cherche à réaliser sont des plots 14 rectangulaires qui présentent une surface supérieure 15 de section longitudinale égale à la section longitudinale des pinces magnétiques que l'on cherche à réaliser.

Dans cet exemple, les plots 14 que l'on cherche à réaliser présentent une surface supérieure 15 de section longitudinale carrée de 1 µm de côté. Bien sûr, d'autres formes de surfaces supérieures pourraient être réalisées en fonction de la forme souhaitée pour les pinces magnétiques à réaliser.

Ces plots 14 sont séparés par des cavités 31 qui sont suffisamment profondes pour que les dépôts effectués par la suite sur les plots soient séparés physiquement des dépôts effectués au fond des cavités. Les plots 14 présentent une surface latérale 32 perpendiculaire à la surface du substrat. Les cavités 31 présentent un fond 29 plan et parallèle à la surface du substrat 12.

Cet ensemble de plots 14 et de cavités 31 peut être réalisé selon différents modes de réalisation.

Selon un premier mode de réalisation, les plots 14 et les cavités 31 sont réalisés dans la couche de résine polymère par lithographie (par exemple optique ou électronique) : cette étape de lithographie passe par une insolation (par exemple par des rayonnements UV) d'une fraction de la couche de résine polymère au travers d'un masque comportant une partie transparente aux rayonnements UV et une partie opaque aux rayonnements UV et définissant les motifs des plots 14 à réaliser. Il se créé alors par réaction photochimique une image latente dans l'épaisseur de la couche de résine polymère photosensible. On développe alors les motifs dans un développeur spécifique à la couche de résine polymère qui attaque préférentiellement soit la fraction de la couche de résine polymère qui a été polymérisée par insolation (résine positive), soit la fraction de la couche de résine polymère non insolée (résine négative). Suite au développement, un ensemble de plots 14 et de cavités 31 de la forme du masque est réalisé à la surface du substrat.

La couche de résine polymère utilisée peut par exemple être du PMMA (polyméthacrylate de méthyle) avec une dilution à 2%. Il est entendu que le PMMA à 2% est ici mentionné à titre purement illustratif pour la couche de résine polymère. On pourrait également utiliser la résine MaN-2403 ou MaN-2405 ou SU8. On pourrait également envisager d'utiliser d'autres matériaux, y compris des matériaux non polymères : la seule condition étant que la couche qui recouvre le substrat puisse être éliminée sélectivement.

Le PMMA est du polyméthylméthacrylate dont la masse moléculaire varie entre 50000 (cinquante mille) et 2.2 million. En général, plus la masse moléculaire sera grande plus la dissolution dans un solvant sera lente.

On peut également utiliser des résines photosensibles DUV (pour « Deep Ultra- Violet » ou ultraviolet lointain) qui sont typiquement des polymères basés sur les polyhydroxystyrènes avec un générateur photoacide procurant le changement de solubilité après exposition.

On peut aussi utiliser une résine photosensible négative amplifiée basée sur des polymères de type époxyde et la libération d'acide de Lewis par le photo-initiateur.

De façon générale, la couche de résine polymère peut être photosensible positive ou négative, ou électrosensible. On notera que la réalisation des plots et des cavités dans la couche de résine photosensible peut également être obtenue par lithographie électronique.

On peut également obtenir ce substrat recouvert de plots 14 de forme choisie par nano-impression de la couche de résine polymère. La nano-impression consiste à utiliser un moule qui contient l'empreinte du relief que l'on cherche à réaliser dans la résine. Suite au dépôt de la couche de résine polymère sur le substrat, on presse cette couche de résine polymère à l'aide du moule. Si le moule contient en relief les motifs des cavités séparant les plots, on retrouve alors directement imprimés dans la résine les plots et des cavités. L'impression est généralement faite à chaud à une température où la résine est relativement fluide. On peut par exemple utiliser une résine SU8 à la température 50°C

Ensuite on refroidit la résine qui se solidifie et on retire le moule délicatement. Le moule est généralement recouvert d'une couche antiadhésive pour faciliter son retrait évitant d'arracher lors du retrait les motifs formés dans la résine.

Une fois ces plots 14 et ces cavités 31 réalisés à la surface du substrat 12, le procédé selon ce mode de réalisation comporte une étape de dépôt d'une multicouche sur l'ensemble de plots et de cavités.

Pour cela, on dépose tout d'abord une première couche mince 16 de matériau magnétique au sommet des plots 14 (figure 4c).

Cette couche mince 16 de matériau magnétique peut par exemple être constituée de permalloy (NiFe), ou d'autres alliages doux à base de Ni, Fe et Co (par exemple Co90Fe10) ou d'alliage terre rare/métaux de transition (par exemple SmCo), ou d'autres matériaux magnétiques. On pourrait également déposer plusieurs couches minces de matériau magnétique, voir même plusieurs couches minces de matériaux magnétiques et ferromagnétiques, selon la composition souhaitée pour la première mâchoire.

Le procédé selon ce mode de réalisation comporte ensuite une étape de dépôt d'une couche sacrificielle 17 sur la couche mince 16. Cette couche sacrificielle 17 peut être une couche de métal, d'isolant, de semiconducteur ou de polymère. La couche sacrificielle peut par exemple être réalisée en aluminium, silice, GaAs, PMMA, ou tout autre matériau que l'on sait ensuite détruire par attaque chimique en milieu liquide ou gazeux. Il est toutefois important que cette couche soit réalisée en un autre matériau que les dits plots 14 sur lesquels la couche 16 est déposée afin que la couche sacrificielle et les plots 14 puissent être retirés sous l'effet d'agents destructeurs différents de façon à pouvoir contrôler indépendamment la disparation de la couche sacrificielle et la disparition des plots 14.

Le procédé selon l'invention comporte ensuite une étape de dépôt d'une deuxième couche mince 18 sur la couche sacrificielle 17 (figure 4d).

Cette deuxième couche mince 18 est également en matériau magnétique. Cette deuxième couche mince 18 peut par exemple être formée du même matériau magnétique ou d'un autre matériau magnétique. A ce stade, on pourrait également déposer plusieurs couches minces de matériaux magnétiques, selon la composition souhaitée pour la deuxième mâchoire.

Comme représenté sur les Figures 1 et 2, ce sont les interactions magnétostatiques entre les aimantations des deux mâchoires qui induisent naturellement l'orientation antiparallèle en champ nul des aimantations à la manière de deux barreaux aimantés dont les pôles opposés s'attirent (attraction pole Nord-pole Sud). L'amplitude de cette interaction magnétostatique peut aisément être estimée par l'homme de l'art en utilisant les expressions classiques de la magnétostatique et en supposant les aimantations des mâchoires monodomaines. Les couches minces 16, 17 et 18 sont par exemple déposées par pulvérisation cathodique, ou par toutes autres méthodes de dépôts de couches minces puissent être utilisées, par exemple l'épitaxie par jet moléculaire, l'électrodéposition, ou l'ADL (« Atomic layer deposition »).

La présence des plots 14 séparés par les cavités 31 permet de découper, suivant la direction longitudinale, les différentes couches 16, 17, 18 déposées à la surface du substrat de façon à ce qu'elles forment un empilement 19 de section longitudinale égale à la section longitudinale de la pince à réaliser.

La forme de la pince magnétique dépend donc de la forme de la surface supérieure des plots 14. La surface supérieure des plots 14 peut prendre n'importe quelle forme, la seule limite étant la résolution de la technique de lithographie ou de nanoimpression servant à réaliser les plots 14 à la surface du substrat. Par exemple, la surface supérieure des plots peut être carrée ou rectangulaire, ronde ou elliptique...

Dans ce premier mode de réalisation, l'empilement 19 est donc formé au sommet des plots 14. Toutefois, on pourrait également envisager d'utiliser l'empilement 19' réalisé au fond des cavités 31. Dans ce cas, la forme de la pince magnétique dépendrait de la forme des cavités 31 entre les plots 14.

Par ailleurs, dans ce cas, si l'on souhaite par la suite pouvoir séparer les minces magnétiques du substrat, il faut, préalablement au dépôt de la couche de résine polymère sur le substrat, déposer une couche support qui recouvre le substrat et qui pourra par la suite être dissoute, ou éliminer sélectivement par une autre méthode, de façon à séparer les empilements qui se trouvent au fond des cavités de la surface du substrat.

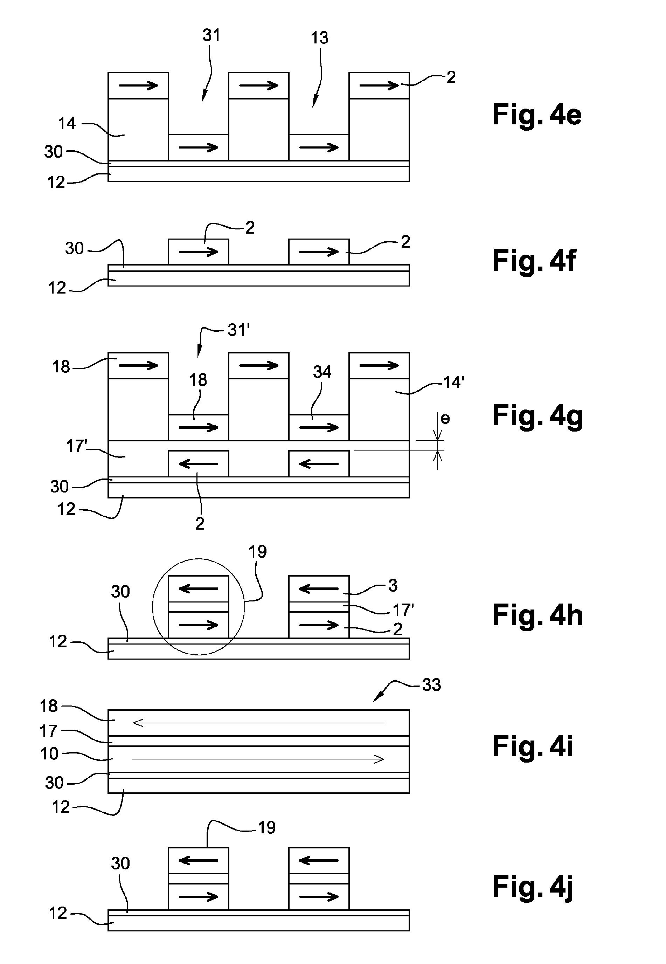

Les figures 4e à 4h représentent les étapes de fabrication de l'empilement 19 selon un autre mode de réalisation de l'invention.

Dans ce mode de réalisation, on part également d'un substrat 12 de surface lisse, par exemple en silicium.

Lorsque l'on souhaite par la suite pouvoir séparer la pince magnétique du substrat 12, on dépose une couche support 30 à la surface de ce substrat 12. Cette couche support 30 est de préférence en polymère qui pourra par la suite être éliminée sélectivement afin de séparer l'empilement 19 du substrat 12. Il s'agit par exemple d'une couche mince en polymère d'épaisseur homogène. Le polymère choisi est par exemple du PMMA (polyméthacrylate de méthyle).

On dépose ensuite une couche de résine en polymère afin de réaliser sur la couche support 30 des plots 14 séparés par des cavités 31. Le procédé permettant de réaliser des plots séparés par des cavités est identique à celui décrit en référence à la figure 4b.

Une première couche mince 16 de matériau magnétique est ensuite déposée sur l'ensemble formé par les plots 14 et les cavités 31. Dans ce mode de réalisation, la partie de la couche mince 16 qui nous intéresse n'est pas la partie qui se trouve au sommet des plots 14 mais il s'agit de la partie de la couche mince qui se trouve au fond des cavités 31. Dans ce mode de réalisation, le relief 13 qui permet de définir la forme de l'empilement 19 est donc constitué par les cavités 31. Ainsi, la forme du fond de chaque cavité correspond à la forme de la pince magnétique à réaliser.

Suite au dépôt de la première couche mince 16, les plots 14 sont dissous (figure 4f). On obtient alors une série de premières mâchoires 2 déposées sur la couche support 30. Une couche sacrificielle 17' est ensuite déposée sur l'ensemble des premières mâchoires 2 de façon à ce que cette couche sacrificielle recouvre entièrement les premières mâchoires.

Cette couche sacrificielle 17' est suffisamment épaisse pour que la partie 34 de la couche sacrificielle 17' qui se trouve au dessus de chaque première mâchoire 2 présente une épaisseur e égale à l'épaisseur voulue pour la couche sacrificielle dans l'empilement 19. En outre, cette couche sacrificielle 17' présente une surface supérieure plane, malgré la présence des premières mâchoires 2 à la surface de la couche support 30.

Comme représenté sur la figure 4g, un ensemble de plots supérieurs 14' et de cavités supérieures 31' est ensuite réalisé à la surface de la couche sacrificielle 17' de façon à ce que chaque cavité supérieure 31' se trouve au dessus d'une des premières mâchoires 2. Les plots supérieurs 14' et cavités supérieures 31' présentent des dimensions identiques à celles des plots 14 et cavités 31 réalisées préalablement sur la couche support 30.

Une deuxième couche mince 18 en matériau magnétique est déposée sur les plots supérieurs 14' et cavités supérieures 31'.

Les techniques de dépôts et les compositions des couches 16, 17' et 18 sont identiques à celles décrites en référence aux figures 4b à 4d.

Les plots supérieurs 14' sont ensuite dissous, ainsi que la partie de la couche sacrificielle 17' qui se trouvait sous ces plots 14'. Par contre, la couche support 30 est épargnée lors de cette étape, ainsi que la partie de la couche sacrificielle 17' qui se trouve entre la première et la deuxième mâchoires de chaque empilement 19. Pour cela, les différentes couches sacrificielles sont dissoutes avec des solvants chimiques de natures différentes, en utilisant la sélectivité de dissolution d'une couche par rapport à l'autre. La couche sacrificielle 17' est éliminée par une gravure anisotrope pour épargner la partie située entre les mâchoires.

On obtient alors des empilements 19 de formes identiques aux formes des pinces à réaliser (figure 4h).

Un troisième procédé de réalisation de l'empilement 19 est représenté sur les figures 4i et 4j.

Dans ce mode de réalisation, on part également d'un substrat 12, par exemple en silice.

Ce substrat 12 est recouvert d'une couche support 30 qui recouvre entièrement la surface du substrat 12. Une première couche mince 16 magnétique est ensuite déposée sur l'ensemble de la couche support 30, puis une couche sacrificielle 17 est déposée sur l'ensemble de la première couche mince 16. Une deuxième couche mince 18 magnétique est ensuite déposée sur l'ensemble de la couche sacrificielle 17.

On obtient alors une multicouche 33 continue qui recouvre entièrement la surface du substrat 12 et qui est formée de la première couche mince magnétique 16, de la deuxième couche mince magnétique 18 et de la couche sacrificielle 17.

Le volume de l'empilement 19 est ensuite défini dans cette multicouche 33 par lithographie optique ou électronique suivie d'une gravure chimique ou par bombardement ionique (figure 4j).

A l'issue de cette première étape, on obtient donc un empilement 19 formé par la première et la deuxième mâchoires 2 et 3, entre lesquelles se trouve une couche sacrificielle qui solidarise entre elles les deux mâchoires.

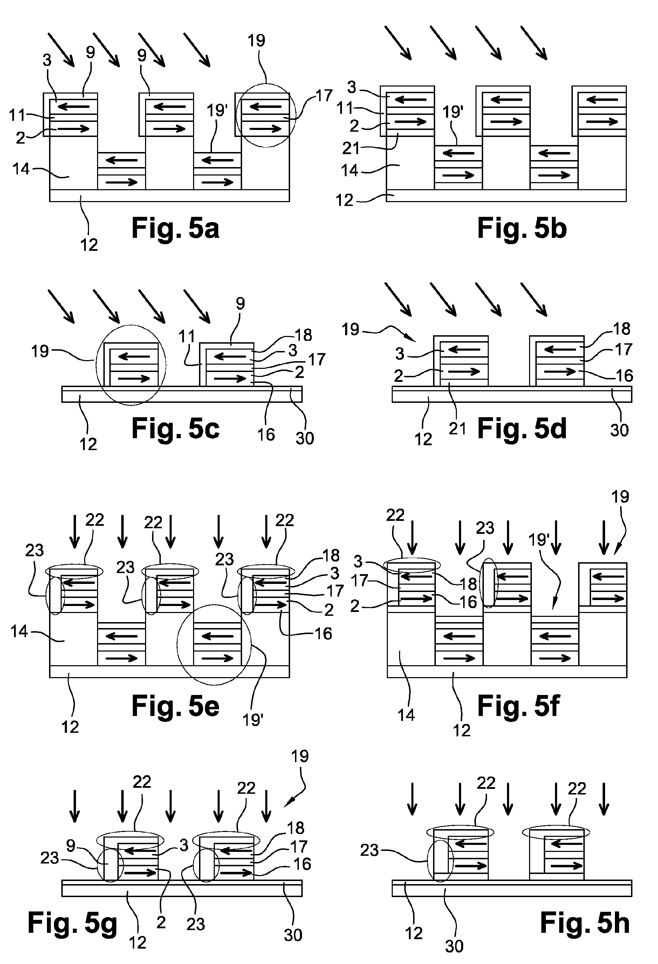

Une fois cet empilement 19 réalisé, le procédé selon l'invention comporte une étape de dépôt d'une charnière 9 qui relie entre elles la première et la deuxième mâchoires. Différents procédés de réalisation de la charnière sont représentés sur les figures 5a à 5h.

La charnière 9 peut être réalisée par dépôt d'une couche mince sur la tranche latérale 11 de l'empilement 19, et éventuellement sur la surface supérieure de l'empilement.

Pour cela, le matériau constitutif de la charnière peut être déposé en incidence oblique (figures 5a à 5d). Le matériau constitutif de la charnière est de préférence déposé par pulvérisation cathodique, mais d'autres techniques de dépôt peuvent être utilisées (épitaxie par jet moléculaire, électrodéposition, ALD...). Le matériau constitutif de la charnière est de préférence un métal ou une polymère élastiquement déformable, par exemple de l'or, de l'argent, du cuivre, du platine....

Le matériau constitutif de la charnière 9 peut également être réalisé par lithographie puis dépôt en incidence oblique (figures 5e à 5h). Dans ce cas, un pilier 23 qui longe la tranche latérale 11 de l'empilement 19 est tout d'abord réalisé par lithographie. Puis, la partie 22 de la charnière qui recouvre la deuxième mâchoire est réalisée par dépôt en incidence normal. Ce dépôt est de préférence réalisé par pulvérisation cathodique, bien que tout autre technique de dépôt puisse être utilisée.

Si l'on souhaite que la charnière recouvre également la face extérieure de la première mâchoire 2 de la pince magnétique, le procédé de réalisation de l'empilement comporte en outre, préalablement à l'étape de dépôt de la première couche 16, une étape de dépôt d'une couche 21 du matériau constitutif de la charnière (figure 5b et 5d).

A la suite de l'étape de réalisation de la charnière 9, le procédé comporte une étape de libération des deux mâchoires par attaque de la couche sacrificielle 17 qui se trouve entre les deux mâchoires. Cette étape d'attaque de la couche sacrificielle 17 peut se faire par gravure ou dissolution chimique, plasma isotrope ou gravure anisotrope de la couche sacrificielle 17.

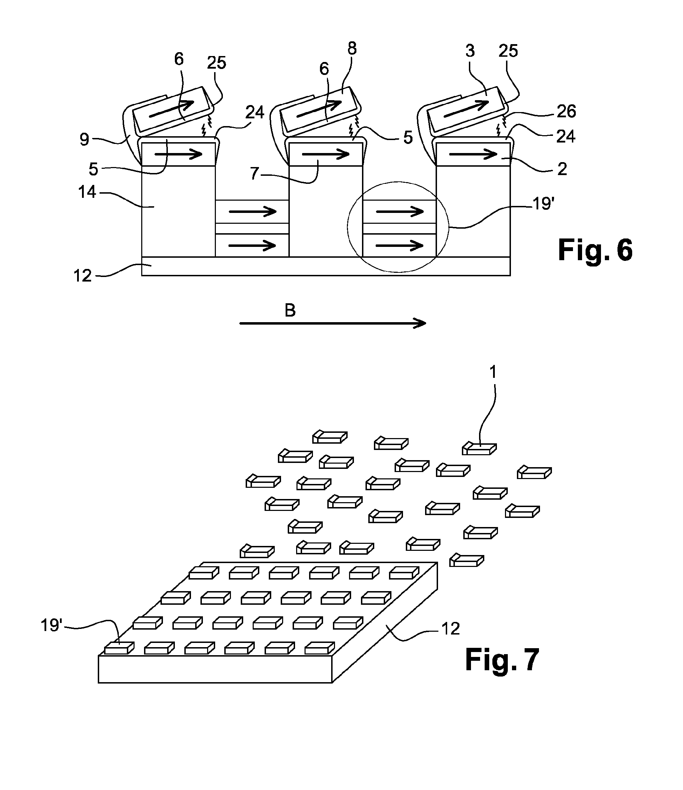

Comme représenté sur la figure 6, le procédé selon l'invention peut également comprendre une étape au cours de laquelle des molécules sont greffées sur la surface intérieure des mâchoires.

Pour cela, il faut avoir au préalable déposé des couches 24, 25 de matériau fonctionnalisable sur les surfaces des mâchoires sur lesquelles on souhaite greffer des molécules. Les couches 24, 25 de matériaux fonctionnalisables sont déposées lors de la fabrication de l'empilement 19.

Dans le cas présent, les couches 24, 25 de matériaux fonctionnalisables ont été déposées sur les surfaces intérieures 5 et 6 de la première et de la deuxième mâchoires. Une première couche 24 de matériau fonctionnalisable a donc été déposée entre l'étape de dépôt de la première couche mince 16 en matériau magnétique et l'étape de dépôt de la couche sacrificielle 17. Une deuxième couche 25 de matériau fonctionnalisable a été déposée entre l'étape de dépôt de la couche sacrificielle 17 et l'étape de dépôt de la deuxième couche 18 en matériau magnétique.

On pourrait également recouvrir les surfaces extérieures 7 et 8 des mâchoires, par des couches de matériaux fonctionnalisables et/ou des couches de matériaux biocompatibles, en fonction de l'utilisation souhaitée de la pince. Pour cela, il faudrait déposer ces couches avant le dépôt de la première couche mince en matériau magnétique 16 et après le dépôt de la deuxième couche mince en matériau magnétique 18.

Les matériaux fonctionnalisables utilisés ici sont par exemple l'or ou la silice.

Dans le cas où le matériau fonctionnalisable est de l'or et de la silice, le dépôt des couches de matériau fonctionnalisable peut se faire par exemple via un dépôt en phase vapeur physique ou PVD (Physical Vapor Deposition), par exemple par pulvérisation cathodique.

Des espèces chimiques ou biologiques 26 peuvent ensuite être greffées sur ces couches de matériaux fonctionnalisables. Lorsque l'on veut greffer ces espèces chimiques ou biologiques à l'intérieur des mâchoires, il faut pour cela ouvrir la pince à l'aide d'un champ magnétique B. Les espèces chimiques ou biologiques sont ensuite greffées à l'intérieur des mâchoires. Pour cela, les espèces chimiques ou biologiques à greffer sont insérées successivement en solution. Par exemple si l'on veut greffer le couple chimique biotine-streptavidine, l'élément chimique Thiol est tout d'abord introduit en solution. Cet élément chimique s'attache alors aux couches de matériaux fonctionnalisables. L'élément chimique thiol permet ensuite de lier à ses extrémités l'élément biotine, élément lui-même destiné à reconnaître et se lier à l'élément streptavidine....

Les espèces chimiques ou biologiques qui peuvent être greffées sur les pinces magnétiques peuvent par exemple être des brins d'ADN ou d'ARN, des anticorps/antigènes, des cellules, des molécules (monomères ou oligomères) ayant par exemple des propriétés de fluorescence ou de phosphorescence, des fibres de polymères (type poly(3-hexylthiophène)), des traceurs radioactifs... On peut également envisager le greffage d'autres objets de forme et/ou de nature différentes, par exemple des objets pour la reconnaissance biologique (anticorps / antigènes), des nanotubes de carbone, de silicium ou d'autres semi-conducteurs.

Le procédé selon l'invention peut également comprendre une étape de séparation des pinces magnétiques du substrat. Une telle étape est représentée sur la figure 7.

Dans le cas où les pinces magnétiques se trouvent au sommet de plots 14 comme représenté sur la figure 6, l'étape de séparation des pinces magnétiques du substrat comporte une étape de dissolution des plots 14. Pour cela, on plonge le substrat 12 recouvert des plots 14 et des pinces magnétiques 1 dans une solution de solvant approprié. Dans le cas où la couche de résine polymère est une couche de PMMA à 2%, le solvant utilisé peut être une solution d'acétone. Bien entendu, d'autres solvants peuvent être utilisés.

Le solvant utilisé doit dissoudre les plots 14 de résine mais sans affecter les espèces greffées sur les mâchoires. Le solvant attaque préférentiellement les plots 14 de résine par leur flanc ce qui libère en premier les pinces magnétiques situées au sommet des plots, lesquelles se retrouvent en suspension dans le solvant. A plus long terme, l'empilement 19' réalisé au fond des cavités est aussi susceptible de se détacher. Pour ne pas avoir à la fois dans le solvant les pinces magnétiques 1 issues du sommet des plots et l'empilement 19' provenant du fond des cavités, il faut donc retirer le substrat du solvant dès que les pinces magnétiques 1 se sont détachées du sommet des plots.

Dans le cas où les pinces magnétiques sont solidaires de la couche support 30 en polymère (figures 4h ou 4j), cette couche support 30 est également dissoute de façon à ce que les pinces magnétiques soient libérées en solution. Dans le cas où cette couche support également en PMMA à 2%, le solvant utilisé pour dissoudre la couche support peut également être de l'acétone.

A l'issue de cette étape, les pinces magnétiques 1 se retrouvent donc en solution. Elles peuvent alors être utilisées directement en solution ou transférées dans une deuxième solution par exemple d'eau tamponnée..

Pour cela, on peut positionner un deuxième substrat à la surface de la solution dans laquelle se trouvent les pinces magnétiques de façon à ce que la surface du deuxième substrat soit au contact de la solution.

On applique ensuite un aimant au dos du deuxième substrat de façon à attirer les pinces magnétiques contre la surface du deuxième substrat. On retire ensuite le substrat et les pinces magnétiques de la solution en gardant l'aimant au dos du substrat. On peut ensuite utiliser les pinces magnétiques sur ce deuxième substrat ou alors les redisperser dans une deuxième solution en faisant la manipulation inverse, c'est-à-dire en positionnant le deuxième substrat avec les pinces magnétiques au contact de la deuxième solution et en retirant l'aimant de l'arrière du deuxième substrat de façon à ce que les pinces magnétiques ne soient plus attirées vers l'aimant et partent dans la deuxième solution.

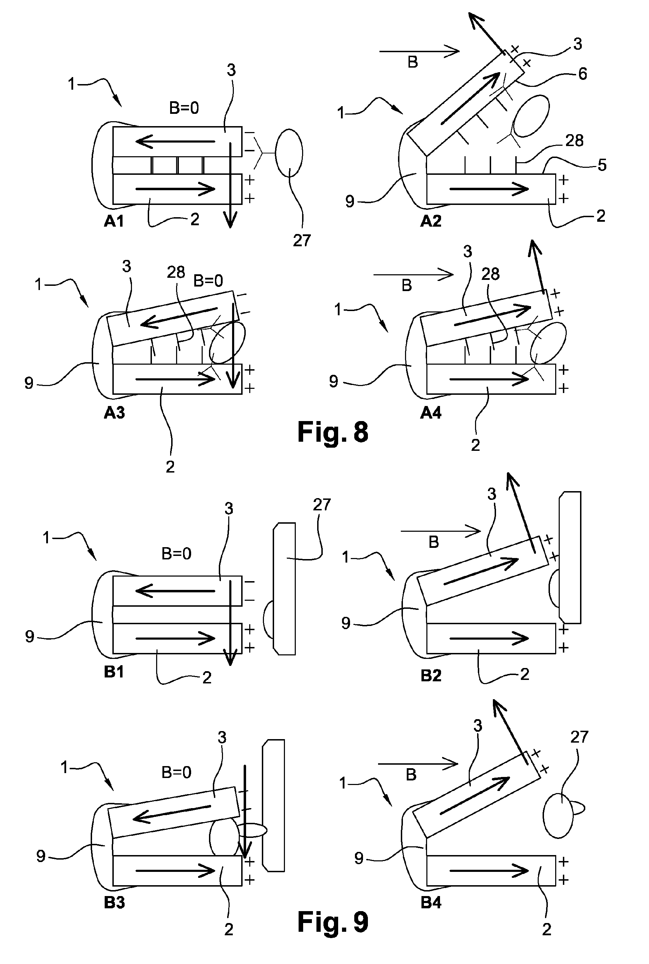

Les figures 8 à 12 représentent différentes utilisations de pinces magnétiques. Les pinces magnétiques utilisées sur ces figures sont des pinces magnétiques identiques à la pince magnétique décrite en référence aux figures 1 a et 1 b, c'est-à-dire qu'elles comportent deux mâchoires présentant un alignement magnétique antiparallèle lorsqu'aucun champ magnétique n'est appliqué, et un alignement magnétique parallèle à l'axe Y lorsqu'un champ magnétique parallèle à l'axe Y est appliqué. Dans toutes les applications décrites en référence aux figures 8 à 12, le champ magnétique B appliqué pour provoquer des mouvements des mâchoires est donc un champ magnétique parallèle à l'axe Y. Bien sur, des pinces magnétiques présentant des mâchoires aux aimantations différentes pourraient être utilisées de la même manière en appliquant un champ magnétique adapté à leur aimantation.

Dans le cas de la figure 8, la pince magnétique est fonctionnalisée avec des molécules sondes 28 fixées sur la surface intérieure 5, 6 des mâchoires 2 et 3 de la pince magnétique 1. Lorsqu'aucun champ magnétique n'est appliqué, la pince magnétique 1 est fermée et aucun objet ne peut être saisi par ses mâchoires (figure 8, A1). Lorsqu'un champ magnétique B est appliqué (figure 8, A2), les mâchoires 2, 3 de la pince magnétique peuvent s'ouvrir et un objet 27 peut venir entre les mâchoires 2 et 3 de la pince. Lorsque l'objet 27 présente une affinité chimique avec les molécules sondes 28 à la surface des mâchoires, il se lie avec ces molécules sondes. Les mâchoires de la pince peuvent ensuite être refermées sur l'objet (figure 8, A3). On peut ensuite mesurer ou calculer la force de liaison moléculaire entre les molécules sondes 28 et l'objet 27 en mesurant le champ B nécessaire pour ouvrir la pince magnétique en présence de l'objet 27 entre ces mâchoires (figure 8, A4). Lorsque la pince magnétique est fonctionnalisée, les objets 27 qui sont captés par la pince magnétique 1 et qui se lient avec les molécules sondes 28 ne peuvent ensuite plus être relâchés en solution par seul actionnement magnétique et ils restent solidaires d'au moins une mâchoire de la pince.

La figure 9 représente une pince magnétique 1 non fonctionnalisée. Cette pince magnétique peut saisir des objets 27 puis les relarguer en solution (figure 9, B4).

La pince magnétique 1 peut également être utilisée pour chauffer un objet 27 pris entre ces mâchoires. Pour cela, une fois que l'objet de trouve entre les mâchoires de la pince, les mâchoires de la pince sont refermées sur l'objet, puis, un champ magnétique B de fréquence élevée (comprise entre quelques dizaine et plusieurs centaines de kilohertz) est appliqué à la pince. La pince s'échauffe alors par hyperthermie. Selon la rigidité de la pince, sa masse et sa viscosité, la pince peut rester quasiment immobile à ces fréquences, et l'objet capturé entre les mâchoires de la pince peut alors être porté à la température du matériau magnétique.

Un tel procédé d'échauffement peut par exemple être utilisé pour détruire des cellules cancéreuses par hyperthermie. Dans ce cas, des pinces magnétiques selon l'invention sont introduites dans le corps humain et guidées grâce à un champ magnétique jusqu'aux cellules cancéreuses, ou transportées à destination par une méthode non magnétique. Les pinces magnétiques sont ensuite ouvertes puis refermées sur les cellules cancéreuses. Un champ magnétique B de fréquence élevée est ensuite appliqué aux pinces magnétiques de façon à détruire les cellules cancéreuses par échauffement. Ce procédé est plus précisément décrit dans le document « Biofunctionalized magnetic-vortex microdiscs for targeted cancer-cell destruction » Dong-Hyun Kim & al, Univ. Chicago, Nature Materials, vol 9, pp 165-171, Feb 2010.

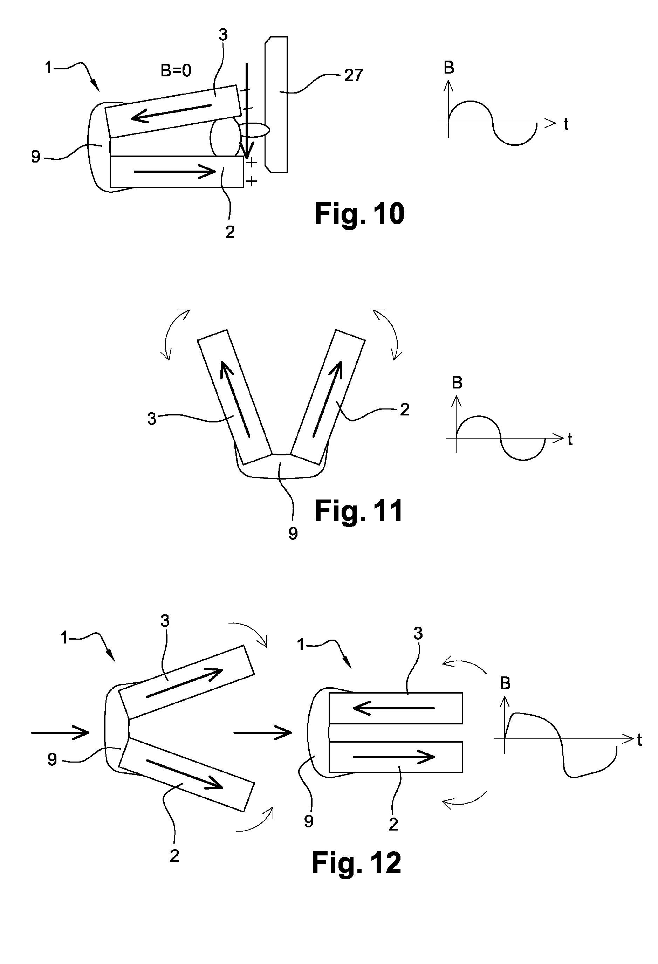

En référence à la figure 11, les pinces magnétiques fabriquées à l'aide du procédé selon l'invention peuvent également être maintenues en suspension dans un fluide. Pour cela, les pinces magnétiques 1 sont plongées dans un fluide, puis un champ magnétique B de fréquence suffisamment basse (c'est-à-dire de fréquence comprise entre quelques hertz et quelques centaines de Hertz) et d'amplitude ajustée est appliqué aux pinces magnétiques de façon à ce que les mâchoires des pinces effectuent des petits battements qui permettent aux pinces magnétiques de rester à la surface du fluide, sans tomber au fond. L'application de ce champ magnétique alternatif permet aux pinces de rester en suspension dans un fluide et donc de mieux circuler dans ce fluide. En effet, si un gradient de champ magnétique est superposé à ce champ magnétique alternatif, les battements de la pince éviteront que la pince magnétique ne s'accroche au fond du récipient qui contient le fluide. Par conséquent, les battements des mâchoires de la pince faciliteront son déplacement.

En référence à la figure 12, le déplacement de la pince magnétique peut également être obtenu en appliquant uniquement un champ magnétique alternatif à la pince. En effet, en appliquant à la pince un champ magnétique alternatif dissymétrique d'amplitude suffisante pour orienter les moments magnétiques des couches magnétiques, et de fréquence comprise entre 1 Hertz et quelques centaines de Hertz, la fréquence et la forme temporelle du champ appliqué étant ajustées en fonction de la viscosité du fluide, on peut créer un effet de « nage » de la pince magnétique. Pour une fréquence donnée, ou une variation temporelle donnée du champ magnétique appliqué, un fluide suffisamment visqueux peut permettre des mouvements de nage plus efficaces qu'un fluide faiblement visqueux, la pince s'appuyant plus fort sur le fluide, mais une viscosité très importante peut aussi réduire l'efficacité de la nage. Un fluide peu visqueux peut nécessiter des fréquences plus élevées ou des variations temporelles du champ plus rapides. Un compromis est à trouver entre la viscosité, et les variations temporelles du champ magnétique appliqué pour obtenir et optimiser la « nage » de la pince. Pour que cette ouverture et fermeture alternative conduise à un mouvement de translation il est nécessaire que le champ magnétique varie alternativement de façon dissymétrique : pour que la pince avance du côté de la charnière, il est nécessaire que la fermeture de la pince soit plus rapide que son ouverture. Au contraire, pour que la pince recule par rapport à la position de la charnière, il faut que l'ouverture soit plus rapide que la fermeture. Cet effet de « nage » de la particule permet donc à la pince magnétique de se déplacer sans gradient de champ appliqué, ce qui est particulièrement avantageux dans les zones éloignées où un gradient de champ serait difficile à obtenir.

Naturellement, l'invention n'est pas limitée aux modes de réalisation décrit en référence aux figures et des variantes peuvent être envisagées sans sortir du cadre de l'invention. On pourra par exemple avoir des mâchoires formées de plusieurs couches minces, magnétiques

## Revendications

1. Procédé de fabrication d'une pince magnétique (1) à la surface d'un substrat (12), la pince magnétique (1) comportant deux mâchoires (2, 3) formées chacune par au moins une couche mince magnétique (16, 18), les deux mâchoires s'étendant suivant une direction longitudinale, les deux mâchoires (2, 3) étant couplées magnétostatiquement, les deux mâchoires (2, 3) étant reliées entre elles par une charnière (9) déformable, la charnière s'étendant suivant une direction transversale, les deux mâchoires (2, 3) pouvant être mises en mouvement l'une par rapport à l'autre sous l'action d'un champ magnétique,
, **caractérisé en ce qu'**il comporte les étapes suivantes :
(i)- formation d'un empilement (19) à la surface du substrat (12), l'empilement (19) comportant au moins deux couches minces magnétiques (16, 18) entre lesquelles se trouve une couche sacrificielle (17), les deux couches minces (16, 18 étant couplées
magnétostâtiquement, l'empilement (19) présentant une section longitudinale égale à la section longitudinale voulue pour la pince magnétique (1) à réaliser, l'empilement présentant une tranche latérale (11) ;
(ii)- dépôt d'une charnière (9) sur au moins la tranche latérale (11) de l'empilement (19);
(iii)- attaque et suppression de la couche sacrificielle (17), après l'étape (ii).

2. Procédé de fabrication selon la revendication précédente, **caractérisé en ce que** l'étape (i) comporte les étapes suivantes :
- formation d'au moins un relief (13) à la surface du substrat (12), le relief présentant une surface supérieure (15) de section longitudinale égale à la section longitudinale voulue pour la pince magnétique (1) à réaliser;
- dépôt d'au moins une première couche mince magnétique (16) sur la surface supérieure (15) de ce relief (13);
- dépôt d'une couche sacrificielle (17) sur la première couche mince (16);
- dépôt d'au moins une deuxième couche mince magnétique (18) à la surface de la couche sacrificielle (17).

3. Procédé de fabrication selon la revendication précédente, **caractérisé en ce que** ce relief (13) est formé par un plot (14) faisant saillie de la surface du substrat (12).

4. Procédé de fabrication selon la revendication 2, **caractérisé en ce que** ce relief (13) est formé par une cavité (31) creusée dans la surface du substrat (12).

5. Procédé selon la revendication précédente, **caractérisé en ce qu'**il comporte, préalablement à l'étape (i) une étape de dépôt d'une couche support (30) à la surface du substrat (12).

6. Procédé selon la revendication 1, **caractérisé en ce que** l'étape (i) de réalisation de l'empilement comporte les étapes suivantes :
- dépôt d'une couche support (30) sur le substrat (12),
- formation d'un premier ensemble de plots (14) et de cavités (31) à la surface de la couche support (30), chaque cavité (31) présentant un fond de section longitudinale égale à la section longitudinale voulue pour la mâchoire inférieure de la pince magnétique à réaliser;
- dépôt d'au moins une première couche mince magnétique (16);
- élimination du premier ensemble de plots (14) et de cavités (31) par gravure ;
- dépôt d'une couche sacrificielle (17') de façon à ce que la surface supérieure de la couche sacrificielle soit plane et que la première couche mince (16) soit entièrement recouverte par la couche sacrificielle ;
- formation d'au moins un deuxième ensemble de plots (14') et de cavités (31') à la surface de la couche sacrificielle (17'), chaque cavité (31') présentant un fond de section longitudinale égale à la section longitudinale voulue pour la mâchoire supérieure de la pince magnétique à réaliser,
- dépôt d'au moins une deuxième couche mince magnétique (18);
- élimination du deuxième ensemble de plots (14') et de cavités (31') et de la partie de la couche sacrificielle qui se trouve à l'extérieur de l'empilement (19) par gravure sélective de façon à ne conserver sur la couche support (30) que l'empilement (19) de section longitudinale égale à la section longitudinale de la mâchoire supérieure de la pince à réaliser.

7. Procédé selon la revendication 1, **caractérisé en ce que** l'étape (i) de réalisation de l'empilement comporte les étapes suivantes :
- dépôt d'au moins une première couche mince magnétique (16) à la surface du substrat (12);
- dépôt d'une couche sacrificielle (17) sur la première couche mince (16);
- dépôt d'au moins une deuxième couche mince magnétique (18) à la surface de la couche sacrificielle (17);
- lithographie de la multicouche formée par la première couche mince magnétique, la deuxième couche mince magnétique et la couche sacrificielle de façon à former un empilement (19) présentant une section longitudinale égale à la section longitudinale voulue pour la pince magnétique (1) à réaliser.

8. Procédé selon l'une quelconque des revendications 1 à 7, dans lequel la surface supérieure du substrat est recouverte d'une couche support (30) en polymère, le procédé comportant en outre une étape de séparation de la pince magnétique du substrat par attaque et suppression de la couche support (30).

9. Procédé selon l'une des revendications précédentes, dans lequel la charnière (9) relie les mâchoires uniquement entre elles et non pas à un support.

10. Procédé selon l'une des revendications précédentes, dans lequel le procédé comporte en outre, suite à l'étape (iii) une étape d'ouverture des mâchoires (2, 3) de la pince et de greffage d'espèces chimiques ou biologiques à l'intérieur des mâchoires de la pince magnétique (1).

11. Procédé selon l'une des revendications précédentes, dans lequel l'étape (i) de formation de l'empilement comprend une ou plusieurs étapes de dépôt d'un matériau biocompatible.

12. Procédé selon l'une des revendications précédentes, l'étape de dépôt de la charnière est réalisée en incidence oblique pour couvrir à la fois la tranche latérale des mâchoires et au moins une partie de la surface supérieure de la deuxième mâchoire.

13. Procédé selon l'une des revendications 1 à 11, dans lequel la charnière comporte une partie perpendiculaire au substrat, cette partie perpendiculaire au substrat étant formée par un pilier défini par lithographie optique ou électronique, le matériau constitutif du pilier étant déposé en incidence perpendiculaire au plan du substrat.

14. Procédé selon l'une des revendications précédentes, dans lequel la couche sacrificielle est supprimée par dissolution à l'aide d'un solvant.

15. Procédé selon l'une des revendications 1 à 13, dans lequel la couche sacrificielle est supprimée par plasma isotrope ou gravure anisotrope.

## Patentansprüche

1. Herstellungsverfahren einer magnetischen Klemme (1) an einer Oberfläche eines Substrats (12), wobei die magnetische Klemme (1) zwei Klemmbacken (2, 3) umfasst, die jeweils durch eine dünne magnetische Schicht (16, 18) gebildet werden, wobei die zwei Klemmbacken sich gemäß einer Längsrichtung erstrecken, wobei die zwei Klemmbacken (2, 3) magnetisch-statisch aneinander gekoppelt sind, wobei die zwei Klemmbacken (2, 3) miteinander durch ein verformbares Scharnier (9) verbunden sind, wobei sich das Scharnier gemäß einer transversalen Richtung erstreckt, wobei die zwei Klemmbacken (2, 3) im Verhältnis zueinander unter der Wirkung eines Magnetfeldes in Bewegung gebracht werden können,
**dadurch gekennzeichnet, dass** es die folgenden Schritte umfasst:
(i) - Bildung einer Stapelung (19) an der Oberfläche des Substrats (12), wobei die Stapelung (19) wenigstens zwei dünne magnetische Schichten (16, 18) umfasst, zwischen denen sich eine Schutzschicht (17) befindet, wobei die zwei dünnen Schichten (16, 18) magnetisch-statisch gekoppelt sind, wobei die Stapelung (19) einen länglichen Abschnitt gleich dem für die zu realisierende magnetische Klemme (1) gewollten länglichen Abschnitt aufweist, wobei die Stapelung eine laterale Tranche (11) aufweist;
(ii) - Aufbringen eines Scharniers (9) auf wenigstens einer lateralen Tranche (11) der Stapelung (19);
(iii) - Angreifen und Entfernung der Schutzschicht (17) nach der Stufe (ii).

2. Herstellungsverfahren gemäß dem voranstehenden Anspruch, **dadurch gekennzeichnet, dass** der Schritt (i) die folgenden Schritte umfasst:
- Bildung wenigstens eines Reliefs (13) an der Oberfläche des Substrats (12), wobei das Relief eine obere Oberfläche (15) mit einem länglichen Abschnitt gleich der für die zu realisierende magnetische Klemme (1) gewollten länglichen Abschnitt aufweist;
- Aufbringen wenigstens einer ersten dünnen magnetischen Schicht (16) auf der oberen Oberfläche (15) dieses Reliefs (13);
- Aufbringen einer Schutzschicht (17) auf der ersten dünnen Schicht (16);
- Aufbringen wenigstens einer zweiten dünnen magnetischen Schicht (18) auf der Oberfläche der Schutzschicht (17).

3. Herstellungsverfahren gemäß dem voranstehenden Anspruch, **dadurch gekennzeichnet, dass** dieses Relief (13) durch ein von der Oberfläche des Substrats (12) hervorstehendes Klötzchen (14) gebildet ist.

4. Herstellungsverfahren gemäß Anspruch 2, **dadurch gekennzeichnet, dass** dieses Relief (13) durch eine in der Oberfläche des Substrats (12) ausgehöhlte Ausnehmung (31) gebildet ist.

5. Herstellungsverfahren gemäß dem voranstehenden Anspruch, **dadurch gekennzeichnet, dass** es vor dem Schritt (i) einen Aufbringungsschritt einer Trägerschicht (30) auf der Oberfläche des Substrats (12) umfasst.

6. Herstellungsverfahren gemäß Anspruch 1, **dadurch gekennzeichnet, dass** der Realisierungsschritt (i) der Stapelung die folgenden Schritte umfasst:
- Aufbringen einer Trägerschicht (30) auf dem Substrat (12),
- Bilden einer ersten Gruppe von Klötzchen (14) und Ausnehmungen (31) an der Oberfläche der Trägerschicht (30), wobei jede Ausnehmung (31) einen Boden mit länglichem Abschnitt gleich dem für die untere Klemmbacke der zu realisierenden magnetischen Klemme gewollten länglichen Abschnitt aufweist;
- Aufbringen wenigstens einer magnetischen dünnen Schicht (16);
- Entfernen der ersten Gruppe von Klötzchen (14) und Ausnehmungen (31) per Gravur;
- Aufbringen einer Opferschicht (17') derart, dass die obere Fläche der Schutzschicht eben ist und dass die erste dünne Schicht (16) komplett von der Schutzschicht abgedeckt ist;
- Bilden von wenigstens einer zweiten Gruppe von Klötzchen (14') und Ausnehmungen (31') an der Oberfläche der Schutzschicht (17'), wobei jede Ausnehmung (31') einen Boden mit länglichem Abschnitt gleich dem für die obere Klemmbacke der zu realisierenden magnetischen Klemme gewollten länglichen Abschnitt aufweise,
- Aufbringen wenigstens einer zweiten dünnen magnetischen Schicht (18);
- Entfernen der zweiten Gruppe von Klötzchen (14') und Ausnehmungen (31') und des Teils der Schutzschicht, die sich außerhalb der Stapelung (19) befindet, durch selektive Gravur derart, dass auf der Trägerschicht (30) nur die Stapelung (19) mit länglichem Abschnitt gleich dem länglichen Abschnitt der oberen Klemmbacke der zu realisierenden Klemme beibehalten wird.

7. Verfahren gemäß Anspruch 1, **dadurch gekennzeichnet, dass** der Realisierungsschritt (i) der Stapelung die folgenden Schritte umfasst:
- Aufbringen wenigstens einer ersten dünnen magnetischen Schicht (16) auf die Oberfläche des Substrats (12);
- Aufbringen einer Schutzschicht (17) auf der ersten dünnen Schicht (16);
- Aufbringen von wenigstens einer zweiten dünnen magnetischen Schicht (18) auf die Oberfläche der Schutzschicht (17);
- Lithographie der durch die erste dünne magnetische Schicht, die zweite dünne magnetische Schicht und die Opferschicht gebildete Mehrfachschicht derart, dass eine Stapelung (19) gebildet wird, die einen länglichen Abschnitt gleich dem für die zu realisierende magnetische Klemme (1) gewollten länglichen Abschnitt aufweist.

8. Verfahren gemäß irgendeinem der Ansprüche 1 bis 7, bei dem die obere Oberfläche des Substrats mit einer Trägerschicht (30) aus Polymer abgedeckt ist, wobei das Verfahren darüber hinaus einen Trennschritt der magnetischen Klemme des Substrats per Angreifen und Entfernung der Trägerschicht (30) umfasst.

9. Verfahren gemäß einem der voranstehenden Ansprüche, bei dem das Scharnier (9) die Klemmbacken ausschließlich miteinander und nicht mit einem Träger verbindet.

10. Verfahren gemäß irgendeinem der voranstehenden Ansprüche, bei dem das Verfahren darüber hinaus im Anschluss an den Schritt (iii) einen Öffnungsschritt der Klemmbacken (2, 3) der Klemme und des Pfropfens von chemischen oder biologischen Sorten im Innern der Klemmbacken de magnetischen Klemme (1) umfasst.

11. Verfahren gemäß irgendeinem der voranstehenden Ansprüche, bei dem der Bildungsschritt (i) der Stapelung einen oder mehrere Aufbringungsschritt(e) eines biokompatiblen Materials umfasst.

12. Verfahren gemäß irgendeinem der voranstehenden Ansprüche, wobei der Aufbringungsschritt des Scharniers in schrägem Einfall realisiert ist, um sowohl die laterale Tranche der Klemmbacken als auch wenigstens einen Teil der oberen Oberfläche der zweiten Klemmbacke abzudecken.

13. Verfahren gemäß irgendeinem der Ansprüche 1 bis 11, bei dem das Scharnier einen zum Substrat lotrechten Teil umfasst, wobei dieser zum Substrat lotrechte Teil durch eine per optischer oder elektronischer Lithographie definierte Säule gebildet ist, wobei das die Säule bildende Material in lotrechte Einfall zur Ebene des Substrats aufgebracht ist.

14. Verfahren gemäß einem der voranstehenden Ansprüche, bei dem die Schutzschicht per Auflösung mithilfe eines Lösungsmittels entfernt ist.

15. Verfahren gemäß irgendeinem der Ansprüche 1 bis 13, bei dem die Schutzschicht per isotropem Plasma oder anisotroper Gravur entfernt ist.

## Claims

1. A method for manufacturing a magnetic clamp (1) at the surface of a substrate (12), the magnetic clamp (1) including two jaws (2, 3) each formed by at least one magnetic thin layer (16, 18), both jaws extending along a longitudinal direction, both jaws (2, 3) being magnetostatically coupled, both jaws (2, 3) being connected to each other by a deformable hinge (9), the hinge extending along a transverse direction, both jaws (2, 3) being movable with respect to each other under the action of a magnetic field,
**characterised in that** it includes the following steps of:
(i) forming a stack (19) at the surface of the substrate (12), the stack (19) including at least two magnetic thin layers (16, 18) between which a sacrificial layer (17) is located, both thin layers (16, 18) being magnetostatically coupled, the stack (19) having a longitudinal cross-section equal to the longitudinal cross-section wanted for the magnetic clamp (1) to be made, the stack having a lateral slice (11);
(ii) depositing a hinge (9) onto at least the lateral slice (11) of the stack (19);
(iii) attacking and removing the sacrificial layer (17), after step (ii).

2. The manufacturing method according to the preceding claim, **characterised in that** step (i) includes the following steps:
- forming at least one relief (13) at the surface of the substrate (12), the relief having an upper surface (15) with a longitudinal cross-section equal to the longitudinal cross-section wanted for the magnetic clamp (1) to be made;
- depositing at least one first magnetic thin layer (16) onto the upper surface (15) of this relief (13);
- depositing a sacrificial layer (17) onto the first thin layer (16);
- depositing at least one second magnetic thin layer (18) at the surface of the sacrificial layer (17).

3. The manufacturing method according to the previous claim, **characterised in that** this relief (13) is formed by a dot (14) projecting from the surface of the substrate (12).

4. The manufacturing method according to claim 2, **characterised in that** this relief (13) is formed by a cavity (31) dug into the surface of the substrate (12).

5. The method according to the preceding claim, **characterised in that** it includes, prior to step (i), a step of depositing a support layer (30) onto the surface of the substrate (12).

6. The method according to claim 1, **characterised in that** the step (i) of making the stack includes the following steps of:
- depositing a support layer (30) onto the substrate (12),
- forming a first set of dots (14) and cavities (31) at the surface of the support layer (30), each cavity (31) having a bottom with a longitudinal cross-section equal to the longitudinal cross-section wanted for the lower jaw of the magnetic clamp to be made;
- depositing at least one first magnetic thin layer (16);
- withdrawing the first set of dots (14) and cavities (31) by etching;
- depositing a sacrificial layer (17') such that the upper surface of the sacrificial layer is planar and that the first thin layer (16) is wholly covered by the sacrificial layer;
- forming at least one second set of dots (14') and cavities (31') at the surface of the sacrificial layer (17'), each cavity (31') having a bottom with a longitudinal cross-section equal to the longitudinal cross-section wanted for the upper jaw of the magnetic clamp to be made,
- depositing at least one second magnetic thin layer (18);
- withdrawing the second set of dots (14') and cavities (31') and the part of the sacrificial layer which is located outside the stack (19) by selective etching so as to keep on the support layer (30) only the stack (19) having a longitudinal cross-section equal to the longitudinal cross-section of the upper jaw of the clamp to be made.

7. The method according to claim 1, **characterised in that** the step (i) of making the stack includes the following steps of:
- depositing at least one first magnetic thin layer (16) at the surface of the substrate (12);
- depositing a sacrificial layer (17) onto the first thin layer (16);
- depositing at least one second magnetic thin layer (18) at the surface of the sacrificial layer (17);
- carrying out the lithography of the multilayer formed by the first magnetic thin layer, the second magnetic thin layer and the sacrificial layer so as to form a stack (19) having a longitudinal cross-section equal to the longitudinal cross-section wanted for the magnetic clamp (1) to be made.

8. The method according to any of claims 1 to 7, wherein the upper surface of the substrate is covered with a support layer (30) of polymer, the method further including a step of separating the magnetic clamp of the substrate by attacking and removing the support layer (30).

9. The method according to one of the preceding claims, wherein the hinge (9) connects the jaws only to each other and not to a support.

10. The method according to one of the preceding claims, wherein the method further includes, following step (iii), a step of opening the jaws (2, 3) of the clamp and grafting chemical or biological species inside the jaws of the magnetic clamp (1).

11. The method according to one of the preceding claims, wherein the step (i) of forming the stack comprises one or more steps of depositing a biocompatible material.

12. The method according to one of the preceding claims, the step of depositing the hinge being made at an oblique incidence to cover both the lateral slice of the jaws and at least one part of the upper surface of the second jaw.

13. The method according to one of claims 1 to 11, wherein the hinge includes a part perpendicular to the substrate, this part perpendicular to the substrate being formed by a pillar defined by optical or electronic lithography, the constituent material of the pillar being deposited at an incidence perpendicular to the plane of the substrate.

14. The method according to one of the preceding claims, wherein the sacrificial layer is removed by dissolution using a solvent.

15. The method according to one of claims 1 to 13, wherein the sacrificial layer is removed by isotropic plasma or anisotropic etching.
